# EUROPEAN PATENT APPLICATION

(11) **EP 4 339 950 A1**
(43) Date of publication of application: **20.03.2024**
(21) Application number: 21951214.2
(22) Date of filing: 27.07.2021
(51) Int. Cl.: G11C 11/22, H10B 53/30

(54) **FERROELECTRIC MEMORY AND FORMATION METHOD THEREFOR, AND ELECTRONIC DEVICE**

(71) Applicant: Huawei Technologies Co., Ltd., Shenzhen, Guangdong 518129 (CN)
(72) Inventor: JING, Weiliang, Shenzhen, Guangdong 518129 (CN); HUANG, Kailiang, Shenzhen, Guangdong 518129 (CN); FENG, Junxiao, Shenzhen, Guangdong 518129 (CN); WANG, Zhengbo, Shenzhen, Guangdong 518129 (CN)
(74) Representative: Thun, Clemens
(86) International application number: PCT/CN2021/108744
(87) International publication number: WO 2023/004598

(57) **Abstract**

Embodiments of this application provide a ferroelectric memory and a forming method thereof, and an electronic device including the ferroelectric memory, to mainly improve storage capacity and storage density of the ferroelectric memory. The ferroelectric memory includes a substrate and a plurality of memory cells formed on the substrate. Each memory cell includes a transistor and a plurality of ferroelectric capacitors. In other words, each memory cell includes at least two ferroelectric capacitors to implement multi-bit data storage. The transistor and the plurality of ferroelectric capacitors are arranged in a first direction perpendicular to the substrate. Any ferroelectric capacitor includes a first electrode layer, a second electrode layer, and a ferroelectric layer formed between the first electrode layer and the second electrode layer. The first electrode layers of every two adjacent ferroelectric capacitors of the plurality of ferroelectric capacitors are in contact, to form a shared first electrode layer that extends in the first direction. In this way, the transistor and the plurality of ferroelectric capacitors are arranged in the direction perpendicular to the substrate, to improve the storage density.

## Description

### TECHNICAL FIELD

This application relates to the field of semiconductor technologies, and in particular, to a ferroelectric memory and a forming method thereof, and an electronic device including the ferroelectric memory.

### BACKGROUND

As a new type of memories, ferroelectric memories are more widely used than traditional dynamic random access memories (dynamic random access memories, DRAMs) thanks to advantages such as non-volatility, a high speed and low power consumption. Existing ferroelectric memories mainly include ferroelectric random access memories (ferroelectric random access memories, FeRAMs) and ferroelectric field effect transistor (ferroelectric filed effect transistor, FeFET) memories.

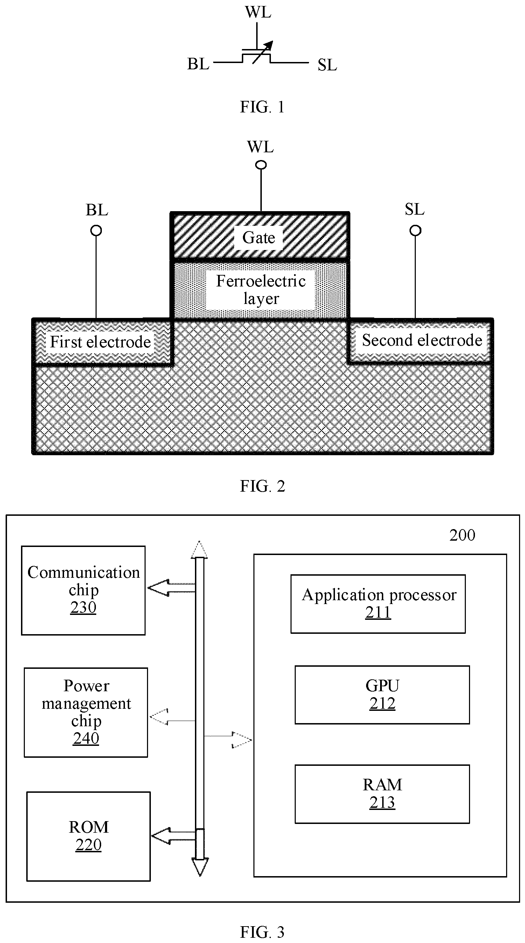

FIG. 1 is a circuit diagram of a memory cell in a FeFET. FIG. 2 is a diagram of a process structure of the memory cell shown in FIG. 1. As shown in FIG. 1 and FIG. 2, the memory cell is a field effect transistor structure that uses a ferroelectric layer to replace a gate dielectric layer, or that includes a ferroelectric layer. For any memory cell, a first electrode of a FeFET in which the memory cell exists is connected to a bit line (bit line, BL), a second electrode of the FeFET is connected to a source line (source line, SL), and a gate of the FeFET is connected to a word line (word line, WL).

In the foregoing FeFET or the existing FeRAM, each memory cell has small storage capacity and can store only one bit of data. Consequently, a read/write speed of the memory may not keep up with an operation speed of a processor, and finally, performance improvement of an electronic product such as a computer or a mobile phone is limited. In addition, it is quite difficult to implement high-density integration of memory cells in the foregoing two memories with different structures, further restricting performance improvement of the memories.

### SUMMARY

This application provides a ferroelectric memory and a forming method thereof, and an electronic device including the ferroelectric memory, to mainly provide the ferroelectric memory that can improve storage capacity and further improve storage density.

To achieve the foregoing objectives, the following technical solutions are used in embodiments of this application.

According to a first aspect, this application provides a ferroelectric memory. The ferroelectric memory includes a substrate and a plurality of memory cells formed on the substrate. Each memory cell includes a transistor and a plurality of ferroelectric capacitors. In other words, each memory cell includes at least two ferroelectric capacitors. The transistor and the plurality of ferroelectric capacitors are arranged in a first direction perpendicular to the substrate. Any ferroelectric capacitor includes a first electrode layer, a second electrode layer, and a ferroelectric layer formed between the first electrode layer and the second electrode layer. The first electrode layers of every two adjacent ferroelectric capacitors of the plurality of ferroelectric capacitors are in contact, to form a shared first electrode layer that extends in the first direction. The shared first electrode layer is electrically connected to the transistor.

In the memory cells of the ferroelectric memory provided in this application, because each memory cell includes at least two ferroelectric capacitors, each memory cell can store multi-bit data information, to improve storage capacity of the memory cell.

In addition, because the transistor and the plurality of ferroelectric capacitors electrically connected to the transistor are arranged in the first direction perpendicular to the substrate, a projection area of each memory cell on the substrate can be reduced, so that more memory cells can be integrated per unit area of the substrate, thereby improving storage density.

In addition, the plurality of ferroelectric capacitors arranged in the first direction share the first electrode layer that extends in the first direction, so that sizes of the plurality of ferroelectric capacitors are further miniaturized.

In a possible implementation of the first aspect, the ferroelectric memory further includes a plate line layer. The plate line layer is located on a first plane parallel to the substrate. The plurality of second electrode layers of the plurality of ferroelectric capacitors located on the first plane are interconnected through the plate line layer.

In other words, in this application, the plurality of ferroelectric capacitors located on the surface parallel to the substrate share a plate line. During specific implementation, a metal layer parallel to the substrate is formed, and the metal layer is referred to as a plate line layer, to electrically connect the plurality of ferroelectric capacitors. In this way, a quantity of disposed plate lines can be reduced, especially a manufacturing process can be simplified, to improve manufacturing efficiency.

In a possible implementation of the first aspect, the transistor and the plurality of ferroelectric capacitors are all manufactured through a back-end-of-line process.

When the transistors and the plurality of ferroelectric capacitors are all manufactured through the back-end-of-line process, a control circuit is manufactured through a front-end-of-line process. The control circuit may include one or more circuits of a translator, a driver, a time sequence controller, a buffer, or an input/output driver, and may further include another functional circuit. The control circuit may control signal lines in embodiments of this application, to be specific, a plate line, a word line, a bit line, and the like. After the front-end-of-line process FEOL is completed, an interconnection line and a memory array are manufactured through the back-end-of-line BEOL process. As described above, the memory array herein includes the plurality of ferroelectric capacitors and the transistor in the memory cell, and also includes a part of the signal lines. The foregoing interconnection line not only includes an interconnection line connecting components in the control circuit, but also includes another part of the foregoing signal lines. The transistor and the ferroelectric capacitors in the memory array are manufactured through the back-end-of-line process, so that circuit density per unit area can be higher, thereby improving storage performance per unit area.

In a possible implementation of the first aspect, the transistor includes a gate, a semiconductor layer, a first electrode, a second electrode, and a gate dielectric layer. The first electrode and the second electrode are arranged in the first direction. The gate is a vertical structure that extends in the first direction. One of two opposite sides of the gate in a second direction has the semiconductor layer. The semiconductor layer is electrically connected to the first electrode and the second electrode. The gate and the semiconductor layer are isolated by the gate dielectric layer. The second direction is a direction parallel to the substrate.

Because the first electrode and the second electrode of the transistor in the memory cell are arranged in the direction perpendicular to the substrate, a transistor formed in this way is a transistor structure with a vertical channel, namely, a transistor with a vertical-plane channel structure. In comparison with a transistor with a horizontal channel, a projection area of the memory on the substrate may be reduced, to improve storage density and improve storage capacity of the electrical memory.

In addition, particularly, in the transistor, the gate is the vertical structure that extends in the first direction, and the semiconductor layer is disposed on one of two opposite sides of the gate in the second direction, instead of surrounding the periphery of the gate. In this way, the size of the entire transistor in the second direction can be miniaturized, and the memory cell can further be miniaturized. Based on these features, the transistor may occupy an area of about 4F². In comparison with a currently occupied area of 6F² or an even larger area, the memory cell is effectively miniaturized, so that more memory cells can be integrated per unit area of the substrate, thereby improving the storage density.

In a possible implementation of the first aspect, the semiconductor layer is a vertical structure that extends in the first direction. One of two opposite ends of the semiconductor layer in the first direction is in contact with the first electrode, and the other end is in contact with the second electrode.

The semiconductor layer is set as the vertical structure, and is in ohmic contact with the first electrode and the second electrode, so that the semiconductor layer forms a vertical channel structure perpendicular to the substrate, thereby further miniaturizing the memory cell.

In a possible implementation of the first aspect, the semiconductor layer is the vertical structure that extends in the first direction. A surface opposite to the second electrode in the first electrode is a first wall surface. A surface opposite to the first electrode in the second electrode is a second wall surface. The one of the opposite two ends of the semiconductor layer in the first direction is in contact with the first wall surface. The other end is in contact with the second wall surface.

In other words, the vertical semiconductor layer is disposed in a region between the first electrode and the second electrode.

In a possible implementation of the first aspect, the semiconductor layer is the vertical structure that extends in the first direction. A surface opposite to the second electrode in the first electrode is a first wall surface. A surface that is in the first electrode and that is adjacent to the first wall surface is a first side surface. A surface opposite to the first electrode in the second electrode is a second wall surface. A surface that is in the second electrode and that is adjacent to the second wall surface is a second side surface. The first side surface and the second side surface are located on a same side. The one of the opposite two ends of the semiconductor layer in the first direction is in contact with the first side surface. The other end is in contact with the second side surface.

In other words, the semiconductor layer is erect on the side on which the first electrode and the second electrode are located.

In a possible implementation of the first aspect, the semiconductor layer includes a first part and a second part both of which extend in the second direction, and a third part that extends in the first direction and that is connected to the first part and the second part. A surface opposite to the second electrode in the first electrode is a first wall surface. A surface opposite to the first electrode in the second electrode is a second wall surface. The first part is disposed on the first wall surface. The second part is disposed on the second wall surface.

In this way, from a perspective of performance of the formed memory cell, a contact area between the semiconductor layer and the first electrode and the second electrode can be increased, to reduce resistance between the first electrode and the semiconductor layer and between the second electrode and the semiconductor layer, increase a current flow rate, and finally improve a read/write speed of the memory cell. From a perspective of a process of forming the memory cell, a manufacturing process can be simplified, and process difficulty can be reduced.

In a possible implementation of the first aspect, the first part, the second part, and the third part are connected to form an integral structure.

In a possible implementation of the first aspect, the semiconductor layer includes a first part that extends in the second direction, and a third part that extends in the first direction and that is connected to the first part. A surface opposite to the second electrode in the first electrode is a first wall surface. A surface opposite to the first electrode in the second electrode is a second wall surface. The memory further includes a connection electrode. The connection electrode is disposed on the second wall surface. The third part is in contact with the first wall surface. The first part is in contact with the connection electrode.

In other words, the semiconductor layer and the gate dielectric layer are both designed to be of a structure close to an L-shaped structure. From a perspective of a process of forming the memory cell, etching process steps in the manufacturing process can be reduced, thereby improving manufacturing efficiency.

In a possible implementation of the first aspect, the surface opposite to the second electrode in the first electrode is the first wall surface. The surface opposite to the first electrode in the second electrode is the second wall surface. The gate is located in a region between the first wall surface and the second wall surface.

The gate is disposed in the region between the first electrode and the second electrode, so that a projection area of the memory cell on the substrate can be further reduced, to further improve integration density.

In a possible implementation of the first aspect, a surface opposite to the second electrode in the first electrode is a first wall surface, and a surface adjacent to the first wall surface in the first electrode is a first side surface. A surface opposite to the first electrode in the second electrode is a second wall surface, and a surface that is in the second electrode and that is adjacent to the second wall surface is a second side surface. The first side surface and the second side surface are on a same side. The gate is located on the side on which the first side surface and the second side surface are located.

In a possible implementation of the first aspect, the transistor is manufactured through a gate-all-around GAA process.

In a possible implementation of the first aspect, the transistor is manufactured through a channel-all-around CAA process.

In a possible implementation of the first aspect, the ferroelectric memory further includes a bit line, a word line, and a plate line. The gate of the transistor is electrically connected to the word line. The first electrode of the transistor is electrically connected to the bit line. The second electrode of the transistor is electrically connected to the shared first electrode layer. The second electrode layer of the ferroelectric capacitor is electrically connected to the plate line.

In a possible implementation of the first aspect, the plurality of memory cells form a first memory array layer and a second memory array layer that are arranged in the first direction. The transistor in the first memory array layer is disposed away from the substrate relative to the plurality of ferroelectric capacitors. The transistor in the second memory array layer is disposed close to the substrate relative to the plurality of ferroelectric capacitors.

Further, the bit line that is in the first memory array layer and that is electrically connected to the transistor may share a same signal line with the bit line that is in the second memory array layer and that is electrically connected to the transistor.

In this way, the size of each memory array layer in a direction perpendicular to the substrate can be reduced, so that more memory array layers are integrated in the direction. Alternatively, the quantity of ferroelectric capacitors in each memory cell can be increased, so that the storage capacity of the memory cell is further improved.

In a possible implementation of the first aspect, the ferroelectric memory further includes a controller. The controller is configured to output a word line control signal to control a voltage on the word line; output a plate line control signal to control a voltage on the plate line; and output a bit line control signal to control a voltage on the bit line.

According to a second aspect, this application further provides a ferroelectric memory. The ferroelectric memory includes a word line, a bit line, a plate line, and a plurality of memory cells. Each memory cell includes a transistor and a plurality of ferroelectric capacitors. Any ferroelectric capacitor includes a first electrode layer, a second electrode layer, and a ferroelectric layer formed between the first electrode layer and the second electrode layer. The transistor includes a first electrode, a second electrode, and a gate. The first electrode of the transistor is electrically connected to the bit line. The second electrode of the transistor is electrically connected to a plurality of first electrode layers of the plurality of ferroelectric capacitors. The gate of the transistor is electrically connected to the word line. The second electrode layer of the ferroelectric capacitor is electrically connected to the plate line.

In the ferroelectric memory provided in this application, because each memory cell includes a plurality of ferroelectric capacitors, multi-bit data can be stored, thereby improving storage capacity of each memory cell.

In a possible implementation of the second aspect, the transistor and the plurality of ferroelectric capacitors are all manufactured through a back-end-of-line process.

When the transistor and the plurality of ferroelectric capacitors are all manufactured through the back-end-of-line process, a control circuit is manufactured through a front-end-of-line process, so that circuit density per unit area can be improved, thereby improving storage performance per unit area.

In a possible implementation of the second aspect, in a write stage, the word line is configured to receive a first word line electrical control signal, so that the transistor is turned on, the bit line is configured to receive a first bit line control signal, the plate line electrically connected to a selected ferroelectric capacitor is configured to receive a first plate line control signal, and a voltage difference between the first bit line control signal and the first plate line control signal enables polarization of the ferroelectric layer of the selected ferroelectric capacitor of the plurality of ferroelectric capacitors.

In a possible implementation of the second aspect, a read stage includes a first read stage, a second read stage, and a third read stage. In the first read stage, the word line is configured to receive the first word line electrical control signal, so that the transistor is turned on, and the bit line is configured to receive a second bit line control signal, to perform voltage pre-charging on the first electrode layer of the selected ferroelectric capacitor. In the second read stage, the word line is configured to receive a second word line electrical control signal, so that the transistor is turned off, the plate line electrically connected to the selected ferroelectric capacitor is configured to receive a second plate line control signal, and a voltage difference between the second plate line control signal and the first electrode layer keeps a polarization direction of the ferroelectric layer of the selected ferroelectric capacitor unchanged, or reverses the polarization direction of the ferroelectric layer of the selected ferroelectric capacitor, to release polarization charges. In the third read stage, the word line is configured to receive the first word line electrical control signal, so that the transistor is turned on, and a voltage or a current on the bit line is detected to read information stored by the selected ferroelectric capacitor.

According to a third aspect, this application further provides an electronic device, including a processor and the ferroelectric memory in any implementation of the first aspect. The processor is electrically connected to the ferroelectric memory.

The electronic device provided in this embodiment of this application includes the ferroelectric memory in the embodiment of the first aspect. Therefore, the electronic device provided in this embodiment of this application and the ferroelectric memory in the foregoing technical solutions can resolve a same technical problem, and achieve a same expected effect.

In a possible implementation of the third aspect, the processor and the ferroelectric memory are integrated into a same chip.

A memory formed in this way may be referred to as an embedded memory structure.

According to a fourth aspect, this application further provides a forming method of a ferroelectric memory. The forming method includes: forming a transistor on a substrate; and
forming a plurality of ferroelectric capacitors, where the transistor and the plurality of ferroelectric capacitors form a memory cell, the transistor and the plurality of ferroelectric capacitors are arranged in a first direction perpendicular to the substrate, any ferroelectric capacitor includes a first electrode layer, a second electrode layer, and a ferroelectric layer formed between the first electrode layer and the second electrode layer, the first electrode layers of every two adjacent ferroelectric capacitors of the plurality of ferroelectric capacitors are in contact, to form a shared first electrode layer that extends in the first direction, and the shared first electrode layer is electrically connected to the transistor.

It should be noted that a manufacturing order of the transistor and the plurality of ferroelectric capacitors is not limited in this application. For example, the transistor may be first integrated, and then the plurality of ferroelectric capacitors are disposed. Alternatively, the plurality of ferroelectric capacitors may be first disposed, and then the transistor is integrated.

Because the manufactured transistor and the plurality of ferroelectric capacitors electrically connected to the transistor are arranged in the first direction perpendicular to the substrate, a projection area of each memory cell on the substrate can be reduced, so that more memory cells can be integrated per unit area of the substrate, thereby improving storage density. In addition, the plurality of ferroelectric capacitors arranged in the first direction share the first electrode layer that extends in the first direction, so that sizes of the plurality of ferroelectric capacitors are further miniaturized.

In a possible implementation of the fourth aspect, before the memory cell is formed, the forming method further includes forming a control circuit on the substrate, and forming, on the control circuit, an interconnection line that electrically connects the control circuit and the memory cell.

In other words, the memory cell in the memory is manufactured through a back-end-of-line process, and the memory cell may be stacked in the direction perpendicular to the substrate through a three-dimensional integration method, to implement high-density integration of the memory.

In a possible implementation of the fourth aspect, the forming a transistor includes: stacking a first conducting layer and a second conducting layer in the first direction, where the first conducting layer and the second conducting layer are insulated; disposing a first groove that runs through the second conducting layer to the first conducting layer; forming a gate dielectric layer on a side wall surface of the first groove; forming a semiconductor layer in remaining space of the first groove; and forming another conducting layer on a side that is of the semiconductor layer and that is away from the first conducting layer, to obtain the transistor.

The transistor formed in this way is a gate-all-around GAA transistor structure.

In a possible implementation of the fourth aspect, the forming a transistor includes: stacking a first conducting layer and a second conducting layer in the first direction, where the first conducting layer and the second conducting layer are in contact, and a part that is of the second conducting layer and that is away from the first conducting layer is exposed outside an insulation layer to form a bare part; sequentially forming a gate dielectric layer, a semiconductor layer, and another conducting layer on the periphery of the bare part, where the another conducting layer is on a side surface of the semiconductor layer; and forming still another conducting layer on the semiconductor layer, to obtain the transistor.

The transistor formed in this way is a channel-all-around CAA transistor structure.

In a possible implementation of the fourth aspect, the forming a transistor includes: sequentially stacking a first conducting layer, a sacrificial layer, and a second conducting layer in the first direction; disposing a first groove that runs through the second conducting layer, the sacrificial layer, and the first conducting layer; sequentially forming a gate dielectric layer and a gate on a side wall surface of the first groove in a second direction parallel to the substrate; removing the sacrificial layer in contact with the gate dielectric layer to form a recess cavity, where a first electrode and a second electrode are formed on two sides of the recess cavity; and forming a semiconductor layer on a wall surface that is of the recess cavity and that is at least close to the gate dielectric layer, to obtain the transistor.

The transistor formed in this way is a vertical-plane channel transistor structure.

In a possible implementation of the fourth aspect, the forming a transistor includes: sequentially stacking a first conducting layer, a sacrificial layer, and a second conducting layer in the first direction; disposing a first groove that runs through the second conducting layer, the sacrificial layer, and the first conducting layer; forming a semiconductor layer on a side wall surface of the first groove in a second direction parallel to the substrate; removing the sacrificial layer in contact with the semiconductor layer to form a recess cavity, where a first electrode and a second electrode are formed on two sides of the recess cavity; and forming a gate, and a gate dielectric layer for isolating the gate from the semiconductor layer in the recess cavity to obtain the transistor.

The transistor formed in this way is a vertical-plane channel transistor structure.

In a possible implementation of the fourth aspect, the forming a transistor includes: sequentially stacking a first conducting layer, a sacrificial layer, and a second conducting layer in the first direction; disposing a first groove that runs through the second conducting layer, the sacrificial layer, and the first conducting layer; removing the sacrificial layer to form a recess cavity, where a first electrode and a second electrode are formed on two sides of the recess cavity; and forming a semiconductor layer, a gate, and a gate dielectric layer for isolating the gate from the semiconductor layer in the recess cavity, to obtain the transistor.

The transistor formed in this way is also a vertical-plane channel transistor structure.

In a possible implementation of the fourth aspect, the forming a transistor includes: sequentially stacking a first conducting layer, a sacrificial layer, and a second conducting layer in the first direction; disposing a first groove that runs to the first conducting layer; sequentially forming a gate dielectric layer and a semiconductor layer on a side surface of the first groove, so that the second conducting layer forms a gate and the first conducting layer forms a first electrode; and forming a second electrode on the semiconductor layer, to obtain the transistor.

The transistor formed in this way is still a vertical-plane channel transistor structure.

### BRIEF DESCRIPTION OF DRAWINGS

FIG. 1 is a circuit diagram of a FeFET in the conventional technology;
FIG. 2 is a diagram of a process structure of the FeFET in the conventional technology;
FIG. 3 is a circuit diagram of an electronic device according to an embodiment of this application;
FIG. 4 is a circuit diagram of a ferroelectric memory according to an embodiment of this application;
FIG. 5 is a circuit diagram of a memory cell of a ferroelectric memory according to an embodiment of this application;
FIG. 6 is a circuit diagram of a memory array of a ferroelectric memory according to an embodiment of this application;
FIG. 7a is a diagram of a process structure of a memory cell of a ferroelectric memory according to an embodiment of this application;
FIG. 7b is a cross-sectional view of FIG. 7a along A-A;
FIG. 8 is a simple schematic top view of a memory array of a ferroelectric memory according to an embodiment of this application;
FIG. 9a is a diagram of a process structure of a memory cell of a ferroelectric memory according to an embodiment of this application;
FIG. 9b is a cross-sectional view of FIG. 9a along B-B;
FIG. 10a is a diagram of a process structure of a memory cell of a ferroelectric memory according to an embodiment of this application;
FIG. 10b is a cross-sectional view of FIG. 10a along C-C;
FIG. 11 is a cross-sectional view of a memory array of a ferroelectric memory according to an embodiment of this application;
FIG. 12 is a cross-sectional view of a memory array of a ferroelectric memory according to an embodiment of this application;
FIG. 13 is a cross-sectional view of a memory array of a ferroelectric memory according to an embodiment of this application;
FIG. 14 is a cross-sectional view of a memory array of a ferroelectric memory according to an embodiment of this application;
FIG. 15 is a diagram of a process structure of a memory array layer of a ferroelectric memory according to an embodiment of this application;
FIG. 16 is a diagram of a process structure of a memory array layer of a ferroelectric memory according to an embodiment of this application;
FIG. 17 is a diagram of a process structure of a memory array layer of a ferroelectric memory according to an embodiment of this application;
FIG. 18 is a diagram of a process structure of two memory array layers of a ferroelectric memory according to an embodiment of this application;
FIG. 19 is a diagram of a process structure of two memory array layers of a ferroelectric memory according to an embodiment of this application;
FIG. 20 is a diagram of a process principle of a chip according to an embodiment of this application;
FIG. 21a to FIG. 21i are diagrams of process structures that are after steps of forming a memory cell are completed according to an embodiment of this application;
FIG. 22a to FIG. 22i are diagrams of process structures that are after steps of forming a memory cell are completed according to an embodiment of this application;
FIG. 23a to FIG. 23i are diagrams of process structures that are after steps of forming a memory cell are completed according to an embodiment of this application;
FIG. 24a to FIG. 24i are diagrams of process structures that are after steps of forming a memory cell are completed according to an embodiment of this application;
FIG. 25a to FIG. 25i are diagrams of process structures that are after steps of forming a memory cell are completed according to an embodiment of this application;
FIG. 26a to FIG. 26i are diagrams of process structures that are after steps of forming a memory cell are completed according to an embodiment of this application.

### Reference numerals:

400, 401, 402, 403, 404-Memory cell; 500, 500a, 500b-Transistor; 51-First electrode; 52-Second electrode; 53-Semiconductor layer; 54-Gate dielectric layer; 55-Gate; 56-Connection electrode; 600, 601, 602, 600a, 600b-Ferroelectric capacitor; 61-First electrode layer; 62-Second electrode layer; 63-Ferroelectric layer; 701, 702-Insulation layer;
3101-First memory array layer; 3102-Second memory array layer; 3103-Third memory array layer;
101, 102, 103, 104, 105-Metal layer; 201-First groove; 202-Second groove; 203-Recess cavity; 204-Third groove; 301-Sacrificial layer.

### DESCRIPTION OF EMBODIMENTS

A ferroelectric memory stores data based on a ferroelectric effect of a ferroelectric material. The ferroelectric memory is expected to be a main competitor of a DRAM and replace the DRAM thanks to advantages of the ferroelectric memory, such as high storage density, low power consumption and a high speed. A memory cell in the ferroelectric memory includes a ferroelectric capacitor, and the ferroelectric capacitor includes two electrodes and the ferroelectric material disposed between the two electrodes, for example, a ferroelectric layer. Due to a nonlinear characteristic of the ferroelectric material, a dielectric constant of the ferroelectric material can be adjusted, and a difference between dielectric constants that are before and after a polarization state of the ferroelectric layer is reversed is excessively large. In this case, the ferroelectric capacitor has a smaller size than another capacitor, for example, a capacitor for storing charges in the DRAM.

In the ferroelectric memory, the ferroelectric layer can be formed by using a common ferroelectric material. When an electric field is applied to the ferroelectric layer of the memory cell, a central atom stops in a low-energy state in the electric field. On the contrary, when an inverse electric field is applied to ferroelectric layer the transistor, the central atom moves in a crystal in the direction of the electric field and stops in another low-energy state. A large quantity of central atoms move and are coupled in a unit cell of the crystal to form a ferroelectric domain (ferroelectric domain), and the ferroelectric domain forms polarization charges under an action of the electric field. The ferroelectric domain forms high polarization charges during electric field inversion, and forms low polarization charges without the electric field inversion. For a binary stable state of the ferroelectric material, the ferroelectric material can be used for a memory.

An embodiment of this application provides an electronic device including a ferroelectric memory. FIG. 3 shows an electronic device 200 according to an embodiment of this application. The electronic device 200 may be a terminal device, for example, a mobile phone, a tablet computer, or a smart band, or may be a personal computer (personal computer, PC), a server, a workstation, or the like. The electronic device 200 includes a bus 205, and a system on chip (system on chip, SoC) 210 and a read-only memory (read-only memory, ROM) 220 that are connected to the bus 205. The SoC 210 may be configured to process data, for example, process data of an application program, process image data, and cache temporary data. The ROM 220 may be configured to store non-volatile data, for example, an audio file or a video file. The ROM 220 may be a PROM (programmable read-only memory, programmable read-only memory), an EPROM (erasable programmable read-only memory, erasable programmable read-only memory), a flash memory (flash memory), or the like.

In addition, the electronic device 200 may further include a communication chip 230 and a power management chip 240. The communication chip 230 may be configured to process a protocol stack, or perform processing such as amplification and filtering on an analog radio frequency signal, or implement the foregoing functions at same time. The power management chip 240 may be configured to supply power to another chip.

In an implementation, the SoC 210 may include an application processor (application processor, AP) 211 configured to process an application program, a graphics processing unit (graphics processing unit, GPU) 212 configured to process image data, and a random access memory (random access memory, RAM) 213 configured to cache data.

The foregoing AP 211, the foregoing GPU 212, and the foregoing RAM 213 may be integrated into one die (die), or may be respectively integrated into a plurality of dies (dies), and are packaged in a packaging structure by using 2.5D (dimension) or 3D packaging technology, another advanced packaging technology, or the like. In an implementation, the foregoing AP 211 and the foregoing GPU 212 are integrated into one die, the RAM 213 is integrated into another die, and the two dies are packaged in a packaging structure, to obtain a faster inter-die data transmission rate and a higher data transmission bandwidth.

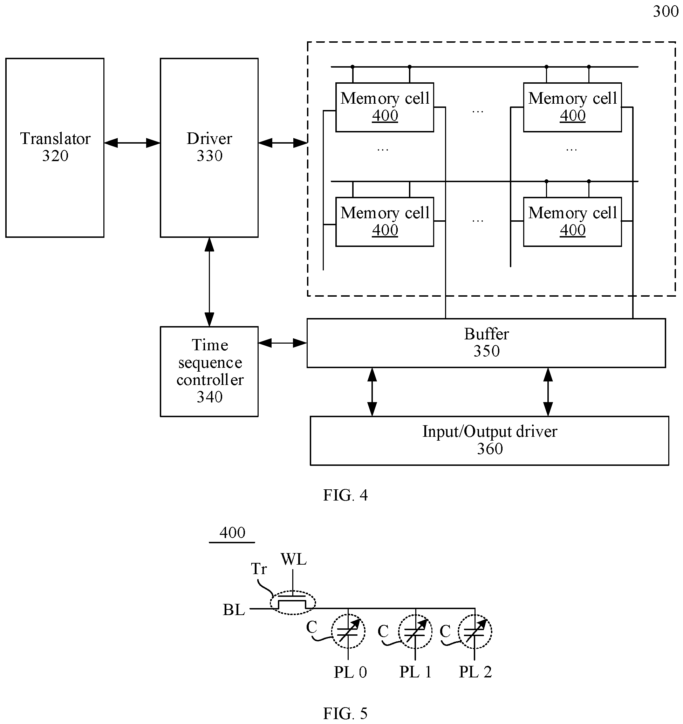

FIG. 4 is a schematic diagram of a structure of a ferroelectric memory 300 according to an embodiment of this application. The ferroelectric memory 300 may be the RAM 213 shown in FIG. 2, and belongs to a FeRAM. In an implementation, the ferroelectric memory 300 may alternatively be a RAM disposed outside the SoC 210. A location of the ferroelectric memory 300 in a device and a location relationship between the ferroelectric memory 300 and the SoC 210 are not limited in this application.

Still as shown in FIG. 4, the ferroelectric memory 300 includes a memory array 310, a translator 320, a driver 330, a time sequence controller 340, a buffer 350, and an input/output driver 360. The memory array 310 includes a plurality of memory cells 400 arranged in an array. Each memory cell 400 may be configured to store multi-bit data. The memory array 310 further includes a word line (word line, WL), a bit line (bit line, BL), and a plate line (plate line, PL). Each memory cell 400 is electrically connected to a corresponding word line WL, a corresponding bit line BL, and a corresponding plate line PL. One or more of the foregoing word line WL, the foregoing bit line BL, or the foregoing plate line PL are configured to select, by receiving a control level output by a control circuit, a to-be-read/written memory cell 400 in the memory array, to change a polarization direction of a ferroelectric capacitor in the memory cell 400, so as to implement a data read/write operation. For convenience, in embodiments of this application, the foregoing word line WL, the foregoing bit line BL, and the foregoing plate line PL are collectively referred to as signal lines.

In the structure of the ferroelectric memory 300 shown in FIG. 4, the translator 320 is configured to perform translation based on a received address, to determine a memory cell 400 that needs to be accessed. The driver 330 is configured to control a level of the signal line based on a translation result generated by the translator 320, to implement access to the specified memory cell 400. The buffer 350 is configured to cache read data, for example, may cache the data through first-in, first-out (first-in, first-out, FIFO). The time sequence controller 340 is configured to control a time sequence of the buffer 350, and control the driver 330 to drive the signal line in the memory array 310. The input/output driver 360 is configured to drive a transmission signal, for example, to drive a received data signal and a data signal that needs to be sent, so that the data signals can be communicated over a long distance.

The foregoing memory array 310, translator 320, driver 330, time sequence controller 340, buffer 350, and input/output driver 360 may be integrated into one chip, or may be integrated into a plurality of chips.

FIG. 5 is a circuit diagram of a memory cell 400 of a ferroelectric memory according to an embodiment of this application. The memory cell 400 includes a transistor Tr, for example, includes a metal-oxide semiconductor field-effect transistor (metal-oxide semiconductor field-effect transistor, MOSFET). The memory cell 400 further includes at least two ferroelectric capacitors C. For example, in FIG. 5, the memory cell 400 includes three ferroelectric capacitors C. It is clear that the memory cell 400 may alternatively include two ferroelectric capacitors C or more ferroelectric capacitors C. In the memory cell 400, a first electrode of the transistor Tr is electrically connected to a bit line BL, a control end of the transistor Tr is electrically connected to a word line WL, first ends of the plurality of ferroelectric capacitors C are all electrically connected to a second electrode of the transistor Tr, and a second end of each ferroelectric capacitor C is electrically connected to a plate line PL.

In this application, one of a drain (drain) or a source (source) of the transistor Tr is referred to as a first electrode, the other electrode is correspondingly referred to as a second electrode, and the control end of the transistor Tr is a gate. The drain and the source of the transistor Tr may be determined based on a flow direction of a current. For example, in FIG. 5, when the current flows from left to right, the left end is the drain, and the right end is the source. On the contrary, when the current flows from right to left, the right end is the drain, and the left end is the source.

It may be understood in this way that the transistor Tr herein is a transistor device having three terminals. Therefore, the transistor Tr may be an NMOS (N-channel metal oxide semiconductor, N-channel metal oxide semiconductor) transistor, or may be a PMOS (P-channel metal oxide semiconductor, P-channel metal oxide semiconductor) transistor.

It can be learned from the circuit diagram of the memory cell 400 shown in FIG. 5 that one memory cell 400 includes a plurality of ferroelectric capacitors C electrically connected to the transistor Tr. In this way, one memory cell 400 can be configured to store multi-bit data, to improve storage capacity of each memory cell. In particular, these ferroelectric capacitors C share one transistor Tr, so that a quantity of transistors of each memory cell 400 may be reduced, thereby improving storage density.

In each memory cell 400 shown in FIG. 5, in a write stage, the word line is configured to receive a word line control signal, so that the transistor Tr is turned on, the bit line is configured to receive a bit line control signal, the plate line electrically connected to a selected ferroelectric capacitor is configured to receive a plate line control signal, and a voltage difference between the bit line control signal and the plate line control signal enables positive polarization or negative polarization of a ferroelectric layer of the selected ferroelectric capacitor, so that different logical information is written into the selected ferroelectric capacitor. For example, when the positive polarization occurs on the ferroelectric layer, a logic signal "0" is written. For another example, when the negative polarization occurs on the ferroelectric layer, a logic signal "1" is written.

In each memory cell 400 shown in FIG. 5, a read stage includes a first read stage, a second read stage, and a third read stage. In the first read stage, the word line is configured to receive the word line control signal, so that the transistor Tr is turned on, the bit line is configured to receive another bit line control signal, to perform voltage pre-charging on a first electrode layer of the selected ferroelectric capacitor. In the second read stage, the word line is configured to receive another word line control signal, so that the transistor Tr is turned off, the plate line electrically connected to the selected ferroelectric capacitor is configured to receive a plate line control signal, and a voltage difference between the plate line control signal and the first electrode layer may keep a polarization direction of the ferroelectric layer of the selected ferroelectric capacitor unchanged, or may reverse the polarization direction of the ferroelectric layer of the selected ferroelectric capacitor, to release polarization charges, so that a voltage on the bit line changes. In the third reading stage, the word line is configured to receive the word line electrical control signal, so that the transistor Tr is turned on, the voltage or a current on the bit line is detected, to determine whether the polarization direction of the selected ferroelectric capacitor is reversed, to read information stored by the ferroelectric capacitor.

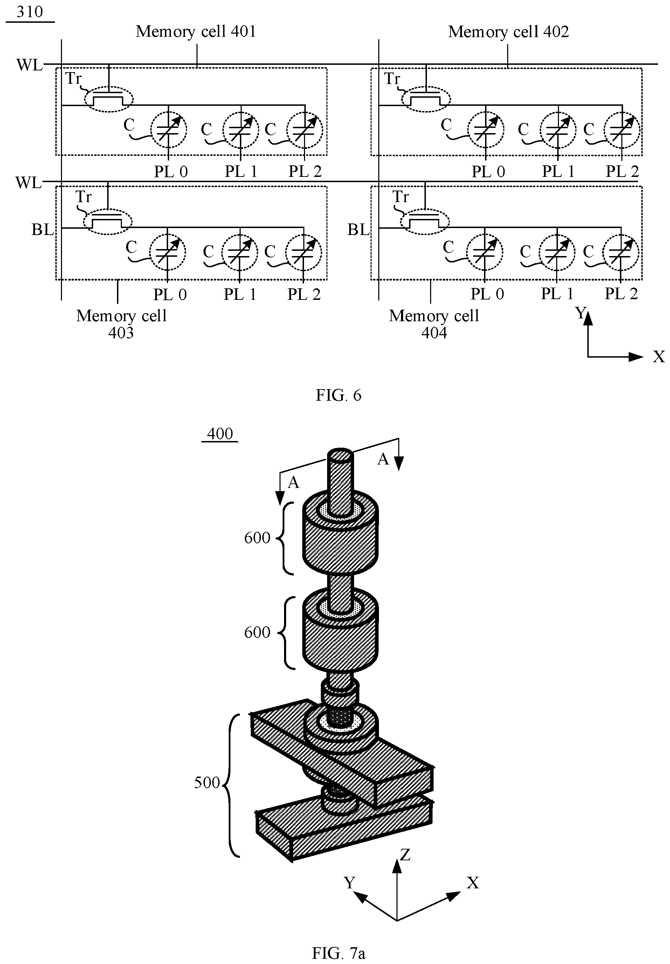

The memory array 310 may be obtained by arranging the foregoing memory cells 400 shown in FIG. 5 in an array. Each memory cell 400 has a same circuit structure. For example, the memory array 310 shown in FIG. 6 includes four memory cells, which are a memory cell 401, a memory cell 402, a memory cell 403, and a memory cell 404. A person skilled in the art may design an arrangement manner of the memory cells 400 in the memory array 310 and the quantity of the memory cells 400 based on a storage capacity requirement of the ferroelectric memory. In an implementation, the memory array 310 may further include more memory cells 400, and these memory cells 400 may be arranged in an X direction, a Y direction, and a Z direction that are perpendicular to each other, to form a three-dimensional memory array.

In an optional implementation, in the memory array 310 shown in FIG. 6, the word line WL extends in the X direction, so that control ends of transistors Tr of a plurality of memory cells arranged in the X direction are electrically connected to the same word line WL. In addition, the bit line BL extends in the Y direction perpendicular to the X direction. In this way, first electrodes of transistors Tr of a plurality of memory cells arranged in the Y direction are electrically connected to the same bit line BL.

The foregoing plate line PL, the foregoing word line WL, and the foregoing bit line BL may receive different control signals respectively. These control signals may be output by a controller, for example, may be controlled by the time sequence controller 340 shown in FIG. 4.

In an implementable implementation, the time sequence controller 340 includes one or more sub-controllers for controlling these signal lines. The one or more sub-controllers and the foregoing signal lines may be in a one-to-one correspondence, or may be in a many-to-many correspondence. For example, the time sequence controller 340 may control all signal lines by using only one sub-controller. Alternatively, the time sequence controller 340 may include three sub-controllers, which are respectively a word line sub-controller, a bit line sub-controller, and a plate line sub-controller. The word line sub-controller is configured to control voltages on all types of word lines, the bit line sub-controller is configured to control voltages on all types of bit lines, and the plate line sub-controller is configured to control voltages on all types of plate lines. These sub-controllers may be integrated into a chip.

The following provides a plurality of different diagrams of process structures of the foregoing memory cell 400. The following respectively provides descriptions with reference to the accompanying drawings.

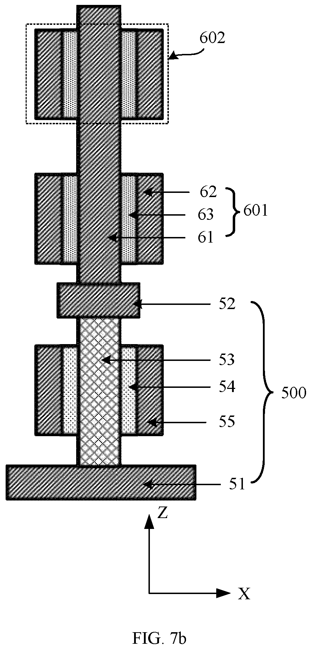

FIG. 7a and FIG. 7b are diagrams of process structures of a memory cell 400. FIG. 7b is a cross-sectional view of FIG. 7a along A-A. With reference to FIG. 7a and FIG. 7b, the memory cell 400 includes a plurality of ferroelectric capacitors 600 (or in other words, includes at least two ferroelectric capacitors 600), and the plurality of ferroelectric capacitors 600 and a transistor 500 are arranged in a direction (for example, a Z direction shown in the figure) perpendicular to a substrate.

In an implementation, as shown in FIG. 7a, the transistor 500 is disposed closer to the substrate than the plurality of ferroelectric capacitors 600, and the plurality of ferroelectric capacitors 600 are sequentially arranged in the Z direction on a side that is of the transistor 500 and that is away from the substrate. In some other optional implementations, the plurality of ferroelectric capacitors 600 may be disposed closer to the substrate than the transistor 500, and the plurality of ferroelectric capacitors 600 are sequentially arranged in the Z direction on a side that is of the transistor 500 and that is close to the substrate.

FIG. 7b is a diagram of a detailed structure of the memory cell 400 in FIG. 7a. In the memory cell 400, each ferroelectric capacitor C includes a first electrode layer 61, a second electrode layer 62, and a ferroelectric layer 63 formed between the first electrode layer 61 and the second electrode layer 62 and configured to store data information. For example, FIG. 7b shows a ferroelectric capacitor 601 and a ferroelectric capacitor 602, and either of the ferroelectric capacitor 601 and the ferroelectric capacitor 602 includes the first electrode layer 61, the second electrode layer 62, and the ferroelectric layer 63.

In an implementable process, a conducting layer may be disposed in the Z direction perpendicular to the substrate. The conducting layer may be used as a shared first electrode layer of the ferroelectric capacitor 601 and the ferroelectric capacitor 602. In other words, in the memory cell 400, the plurality of ferroelectric capacitors share the first electrode layer, and the shared first electrode layer extends in the direction perpendicular to the substrate, so that the plurality of ferroelectric capacitors may be arranged in the direction perpendicular to the substrate.

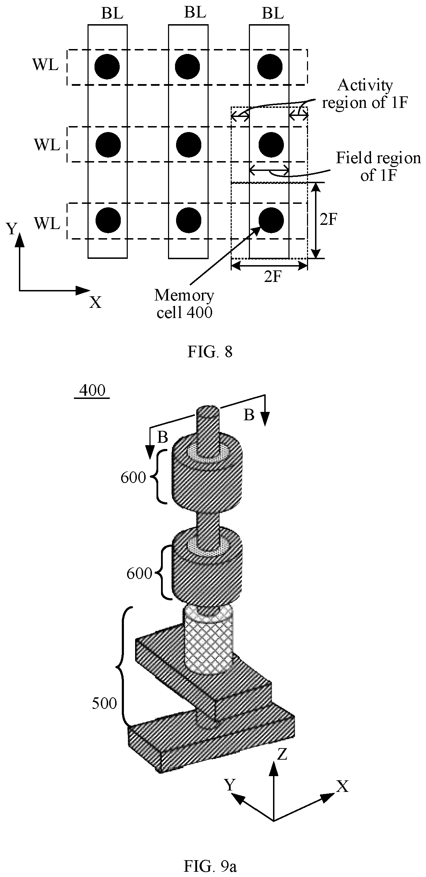

When the plurality of ferroelectric capacitors are arranged in the direction perpendicular to the substrate, when multi-bit data storage can be implemented, a projection area on the substrate may be further reduced to implement miniaturization of the memory cell 400, so that more memory cells are integrated per unit area of the substrate. For example, as shown in FIG. 8, a memory cell 400 in the ferroelectric memory has only an activity region of 1F and a field region of 1F in the X direction and the Y direction respectively. Finally, the memory cell 400 occupies a region of 2F x 2F = 4F². On a premise of implementing multi-bit data storage, storage density can be obviously improved.

As shown in FIG. 7b, the transistor 500 of the memory cell 400 provided in this application includes a first electrode 51, a second electrode 52, a semiconductor layer 53, and a gate 55. The semiconductor layer 53 may also be referred to as a channel layer. The transistor 500 further includes a gate dielectric layer 54 that isolates the semiconductor layer 53 from the gate 55. In addition, the gate 55 and the first electrode 51 are insulated, and the gate 55 and the second electrode 52 are also insulated.

The foregoing first electrode 51 and the foregoing second electrode 52 are both made of a conducting material, for example, a metal material. In an optional implementation, the first electrode 51 and the second electrode 52 may be made of one or more of conducting materials such as TiN (titanium nitride), Ti (titanium), Au (aurum), W (tungsten), Mo (molybdenum), In-Ti-O (ITO, indium tin oxide), Al (aluminum), Cu (cuprum), Ru (ruthenium), and Ag (argentum).

The foregoing gate 55 is made of a conducting material, for example, a metal material. In an optional implementation, the foregoing gate 55 may be made of one or more of conducting materials such as TiN (titanium nitride), Ti (titanium), Au (aurum), W (tungsten), Mo (molybdenum), In-Ti-O (ITO, indium tin oxide), Al (aluminum), Cu (cuprum), Ru (ruthenium), and Ag (argentum).

The foregoing semiconductor layer 53 may be made of one or more of semiconductor materials such as Si (silicon), poly-Si (p-Si, polycrystalline silicon), amorphous-Si (a-Si, amorphous silicon), an In-Ga-Zn-O (IGZO, indium gallium zinc oxide) multi-composite compound, ZnO (zinc oxide), ITO (indium tin oxide), TiO₂ (titanium dioxide), MoS₂ (molybdenum dioxide), and WS₂ (tungsten disulfide).

Insulation layers used for insulating the foregoing gate 55 and the foregoing first electrode 51 and insulating the foregoing gate 55 and the foregoing second electrode 52 may be made of one or more of insulation materials such as SiO₂ (silicon dioxide), Al₂O₃ (aluminum oxide), HfO₂ (propylene dioxide), ZrO₂ (zirconium dioxide), TiO₂ (titanium dioxide), Y₂O₃ (yttrium (III) oxide), and Si₃N₄ (silicon nitride).

The foregoing gate dielectric layer 54 may be made of one or more of insulation materials such as SiO₂ (silicon dioxide), Al2O₃ (aluminum oxide), HfO₂ (propylene dioxide), ZrO₂ (zirconium dioxide), TiO₂ (titanium dioxide), Y₂O₃ (yttrium (III) oxide), and Si₃N₄ (silicon nitride).

The foregoing ferroelectric layer 63 may be made of one or more of ferroelectric materials or materials doped with another element based on the materials, such as ZrO₂, HfO₂, Al doped HfO₂, Si doped HfO₂, Zr doped HfO₂, La doped HfO₂, and Y doped HfO₂.

The foregoing first electrode layer 61 and the foregoing second electrode layer 62 are both made of a conducting material, which is, for example, one or more of conducting materials such as TiN (titanium nitride), Ti (titanium), Au (aurum), W (tungsten), Mo (molybdenum), In-Ti-O (ITO, indium tin oxide), Al (aluminum), Cu (cuprum), Ru (ruthenium), and Ag (argentum).

In this application, the foregoing transistor 500 may be a gate-all-around field-effect transistor (Gate-All-Around Field-Effect Transistor, GAA FET), a channel-all-around field-effect transistor (Channel-All-Around Field-Effect Transistor, CAA FET), or a vertical-plane channel transistor.

FIG. 7b shows an example of an optional gate-all-around field-effect transistor GAA FET structure of the transistor 500. The first electrode 51 and the second electrode 52 of the transistor 500 are arranged in the Z direction perpendicular to the substrate. The semiconductor layer 53 is formed between the first electrode 51 and the second electrode 52, and is electrically connected to the first electrode 51 and the second electrode 52 in ohmic contact. The gate 55 surrounds the periphery of the semiconductor layer 53. In addition, the gate 55 and the semiconductor layer 53 are isolated by the gate dielectric layer 54.

In the structure of the transistor 500 shown in FIG. 7a and FIG. 7b, the first electrode 51, the second electrode 52, and the semiconductor layer 53 are all film layer structures, and may be formed, for example, through processes such as deposition and sputtering instead of doping on the substrate. In this way, the memory cell can be stacked in a 3D manner on the substrate, to implement high-density integration of the memory cells.

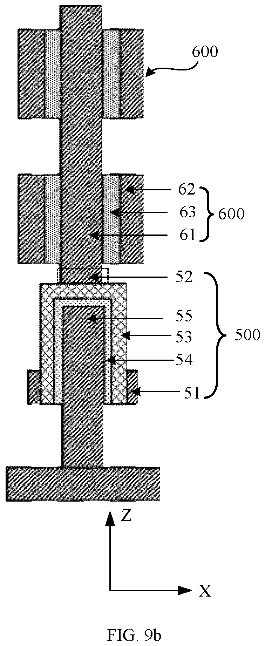

FIG. 9a and FIG. 9b are diagrams of a process structure of another memory cell 400. FIG. 9b is a cross-sectional view of FIG. 9a along B-B. Similarities between the memory cell 400 shown in FIG. 9a and FIG. 9b and the foregoing memory cell 400 shown in FIG. 7a and FIG. 7b lie in that a transistor 500 and a plurality of ferroelectric capacitors 600 are arranged in a Z direction perpendicular to a substrate, the plurality of ferroelectric capacitors may share a first electrode layer 61, and the first electrode layer 61 extends in the Z direction perpendicular to the substrate.

A difference between this memory cell 400 and the foregoing memory cell 400 shown in FIG. 7a and FIG. 7b lies in that the transistor 500 in this embodiment has a channel-all-around field-effect transistor CAA FET structure. With reference to FIG. 9a and FIG. 9b, a first electrode 51 and a second electrode 52 of the transistor 500 are arranged in the direction perpendicular to the substrate, and a gate 55 also extends in the direction perpendicular to the substrate. In addition, a semiconductor layer 53 surrounds the periphery of the gate 55, so that the gate dielectric layer 54 isolates the gate 55 from the semiconductor layer 53, and the CAA FET structure is formed.

In the structure shown in FIG. 9b, the second electrode 52 is electrically connected to the shared first electrode layer 61 of the plurality of ferroelectric capacitors. Therefore, in an implementable process, a conducting layer may be arranged in the direction perpendicular to the substrate, a part that is of the conducting layer and that is in contact with the semiconductor layer 53 is used as the second electrode 52 of the transistor 500, and a remaining part is used as the shared first electrode layer 61.

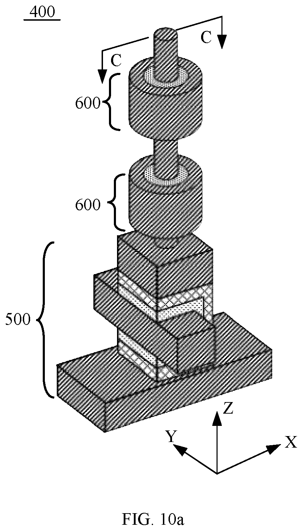

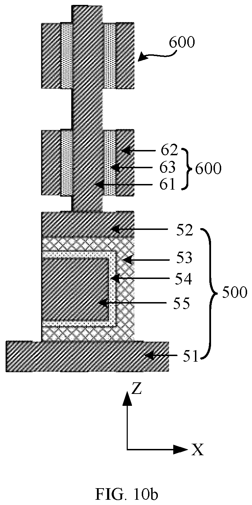

FIG. 10a and FIG. 10b are diagrams of a process structure of another memory cell 400. FIG. 10b is a cross-sectional view of FIG. 10a along C-C. Similarities between the memory cell 400 shown in FIG. 10a and FIG. 10b and the foregoing memory cell 400 shown in FIG. 9a and FIG. 9b lie in that a transistor 500 and a plurality of ferroelectric capacitors 600 are also arranged in a Z direction perpendicular to a substrate, the plurality of ferroelectric capacitors may share a first electrode layer 61, and the first electrode layer 61 extends in the Z direction perpendicular to the substrate.

A difference between this memory cell 400 and the foregoing memory cell 400 shown in FIG. 9a and FIG. 9b lies in that the transistor 500 in this embodiment is a vertical-plane channel transistor. With reference to FIG. 10a and FIG. 10b, a first electrode 51 and a second electrode 52 of the transistor 500 are arranged in the Z direction perpendicular to the substrate. A semiconductor layer 53 with a recess cavity is formed between the first electrode 51 and the second electrode 52. A gate 55 is located in the recess cavity. In addition, the gate 55 and the semiconductor layer 53 are isolated by a gate dielectric layer 54 located in the recess cavity. It may alternatively be understood that the semiconductor layer 53 includes a first part in contact with the first electrode 51 and a second part in contact with the second electrode 52, where the first part and the second part both extend in a direction parallel to the substrate, and further includes a third part connecting the first part and the second part. In an implementable process, a structure with a recess cavity is formed by using the first part, the second part, and the third part that are integrated.

In this embodiment, the semiconductor layer 53 is a structure with the recess cavity, and the gate 55 and the gate dielectric layer 54 are both accommodated in the recess cavity. In terms of performance of a transistor in which this structure is formed, because a wall surface that is of the first electrode 51 and that faces the second electrode 52 and a wall surface that is of the second electrode 52 and that faces the first electrode 51 both have the semiconductor layer 53, an ohmic contact area between the semiconductor layer 53 and the first electrode 51 can be increased, and an ohmic contact area between the semiconductor layer 53 and the second electrode 52 can be increased, so that resistance between the semiconductor layer 53 and the first electrode 51 is reduced, and resistance between the semiconductor layer 53 and the second electrode 52 is reduced, thereby increasing a current flow rate, and finally increasing a read/write speed of the memory cell.

In addition, because the gate 55 and the gate dielectric layer 54 are contained in the recess cavity formed by the semiconductor layer 53, the size of the memory cell 400 can be further miniaturized, thereby implementing high-density storage.

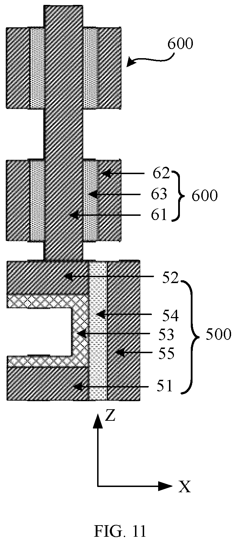

FIG. 11 is a cross-sectional view of a process structure of another memory cell 400. A transistor 500 in the memory cell 400 is also a vertical-plane channel transistor. A similarity between this transistor and the foregoing transistor shown in FIG. 10b lies in that a semiconductor layer 53 is also a structure with a recess cavity. A difference lies in that a gate 55 and a gate dielectric layer 54 are disposed at different positions. In the structure shown in FIG. 11, the gate 55 is disposed on the side of a first electrode 51 and a second electrode 52. In addition, the gate 55 and the first electrode 51, the gate 55 and the second electrode 52, and the gate 55 and the semiconductor layer 53 are all isolated by the gate dielectric layer 54.

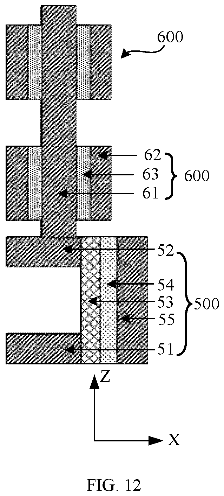

FIG. 12 is a cross-sectional view of a process structure of another memory cell 400. A transistor 500 in the memory cell 400 is also a vertical-plane channel transistor. As shown in FIG. 12, a semiconductor layer 53, a gate dielectric layer 54, and a gate 55 are all disposed on a side surface of a first electrode 51 and a side surface of a second electrode 52. In other words, the semiconductor layer 53, the gate dielectric layer 54, and the gate 55 are sequentially arranged on the side of the first electrode 51 and the second electrode 52 in a direction parallel to a substrate.

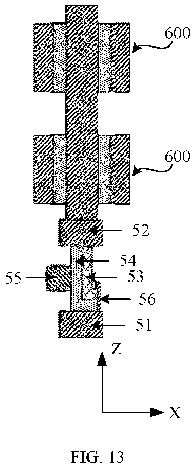

FIG. 13 is a cross-sectional view of a process structure of another memory cell 400. A transistor 500 in the memory cell 400 is also a vertical-plane channel transistor. As shown in FIG. 13, a semiconductor layer 53 and a gate dielectric layer 54 are both of a structure close to an L-shaped structure. A connection electrode 56 is further disposed on a surface that is of a first electrode 51 and that faces a second electrode 52. One end of the semiconductor layer 53 and one end of the gate dielectric layer 54 are both in contact with the second electrode 52, and the other end of the semiconductor layer 53 and the other end of the gate dielectric layer 54 are in contact with the connection electrode 56. It may alternatively be understood in this way: The semiconductor layer 53 includes a first part parallel to a substrate and a third part perpendicular to the substrate, where the first part is in contact with the connection electrode 56, and the third part is in contact with the second electrode 52.

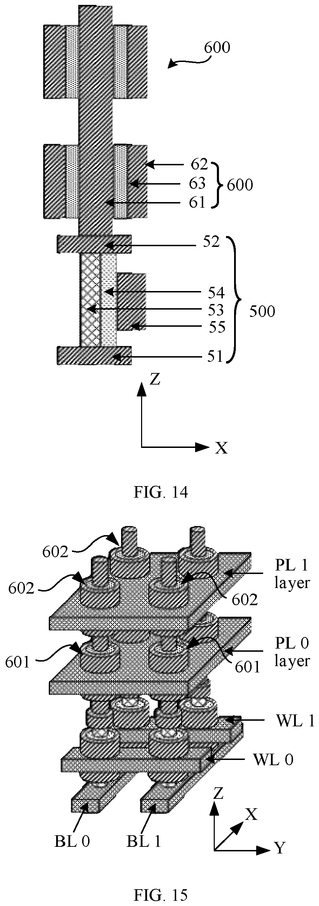

FIG. 14 is a cross-sectional view of a process structure of another memory cell 400. A transistor 500 in the memory cell 400 is also a vertical-plane channel transistor. As shown in FIG. 14, a semiconductor layer 53 is a vertical structure that extends in a direction perpendicular to a substrate. In addition, one end of two opposite ends of the semiconductor layer 53 is in contact with a surface that is of a first electrode 51 and that faces a second electrode 52, the other end of the two opposite ends of the semiconductor layer 53 is in contact with a surface that is of the second electrode 52 and that faces the first electrode 51. A gate 55 is located on a side of the semiconductor layer 53 and is isolated from the semiconductor layer 53 by a gate dielectric layer 54. In other words, the semiconductor layer 53, the gate dielectric layer 54, and the gate 55 are sequentially arranged between the first electrode 51 and the second electrode 52 in a direction parallel to the substrate.

In conclusion, for the memory cells 400 of different structures, the transistor and the plurality of ferroelectric capacitors in the memory cell 400 are arranged in the direction perpendicular to the substrate. In this way, a projection area on the substrate can be reduced, a quantity of memory cells integrated per unit area of the substrate can be increased, and high-density integration is implemented. In addition, multi-bit data can be stored, so that storage capacity of each memory cell can be improved.

The foregoing memory cells 400 of different structures may be arranged in the X direction, the Y direction, and the Z direction that are perpendicular to each other, to form a memory array. FIG. 15 shows a structure of a memory array including the foregoing memory cells. In the memory array, a 2 x 2 matrix is provided as an example. In the memory array, word lines WL extend in the Y direction parallel to the substrate, and gates of transistors of a plurality of memory cells arranged in the Y direction are electrically connected to a same word line WL. In addition, bit lines BL extend in the X direction (where the X direction may be perpendicular to the Y direction) parallel to the substrate, and first electrodes of transistors of a plurality of memory cells arranged in the X direction are electrically connected to a same bit line BL.

In particular, because each memory cell has a plurality of ferroelectric capacitors arranged in the Z direction, for example, each memory cell in FIG. 15 has two ferroelectric capacitors, which are respectively a ferroelectric capacitor 601 and a ferroelectric capacitor 602, there are a plurality of ferroelectric capacitors in an X-Y plane perpendicular to the Z direction. For example, in FIG. 15, there are four ferroelectric capacitors in the X-Y plane. In an implementation, second electrode layers of the plurality of ferroelectric capacitors located in the X-Y plane are interconnected through shared plate lines PL. In an implementable structure, as shown in FIG. 15, a metal layer may be disposed in the X-Y plane. The metal layer is used as a plate line PL layer structure, and the plate line PL layer structure surrounds the second electrode layers of all the ferroelectric capacitors in the X-Y plane, to form a shared plate line PL structure. For example, in FIG. 15, two parallel plate line PL layer structures are formed. The plate line PL layer structure close to the transistor surrounds second electrode layers of all ferroelectric capacitors 601 in the X-Y plane, and the plate line PL layer structure away from the transistor surrounds second electrode layers of all ferroelectric capacitors 602 in the X-Y plane.

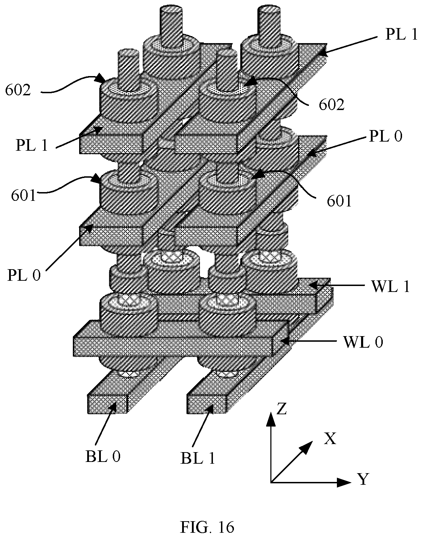

FIG. 16 shows a diagram of a process structure of another memory array. Similarities between the process structure of this memory array and the foregoing process structure of the memory array shown in FIG. 15 lie in that word lines WL also extend in a Y direction parallel to a substrate, and gates of transistors of a plurality of memory cells arranged in the Y direction are electrically connected to a same word line WL. In addition, bit lines BL also extend in an X direction parallel to the substrate (where the X direction may be perpendicular to the Y direction), and first electrodes of transistors of a plurality of memory cells arranged in the X direction are electrically connected to a same bit line BL. A difference between the process structure of the memory array shown in FIG. 16 and the foregoing process structure of the memory array shown in FIG. 15 lies in that the extension direction of each plate line PL is consistent with the extension direction of the bit lines BL, that is, the plate line PL also extends in the X direction. Therefore, second electrode layers of a plurality of ferroelectric capacitors arranged in the X direction in an X-Y plane are electrically connected to a same plate line PL, and a plurality of plate lines PL in the X-Y plane are independent of each other.

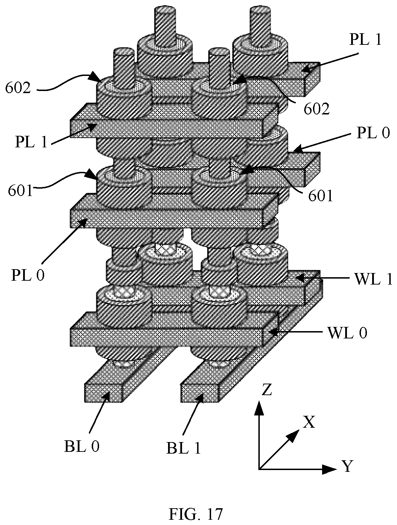

FIG. 17 shows a diagram of a process structure of another memory array. Similarities between the process structure of this memory array and the foregoing process structure of the memory array shown in FIG. 15 lie in that word lines WL also extend in a Y direction parallel to a substrate, and gates of transistors of a plurality of memory cells arranged in the Y direction are electrically connected to a same word line WL. In addition, bit lines BL also extend in an X direction parallel to the substrate (where the X direction may be perpendicular to the Y direction), and first electrodes of transistors of a plurality of memory cells arranged in the X direction are electrically connected to a same bit line BL. A difference between the process structure of the memory array shown in FIG. 17 and the foregoing process structure of the memory array shown in FIG. 15 lies in that the extension direction of each plate line PL is consistent with the extension direction of the word lines WL, that is, the plate line PL extends in the Y direction. Therefore, second electrode layers of a plurality of ferroelectric capacitors arranged in the Y direction in an X-Y plane are electrically connected to a same plate line PL, and a plurality of plate lines PL in the X-Y plane are independent of each other.

FIG. 15 to FIG. 17 show a memory array structure layer of a memory. In the memory array structure layer, the quantity of ferroelectric capacitors of each memory cell is not limited to the two ferroelectric capacitors shown in FIG. 15 to FIG. 17, and may alternatively be more ferroelectric capacitors.

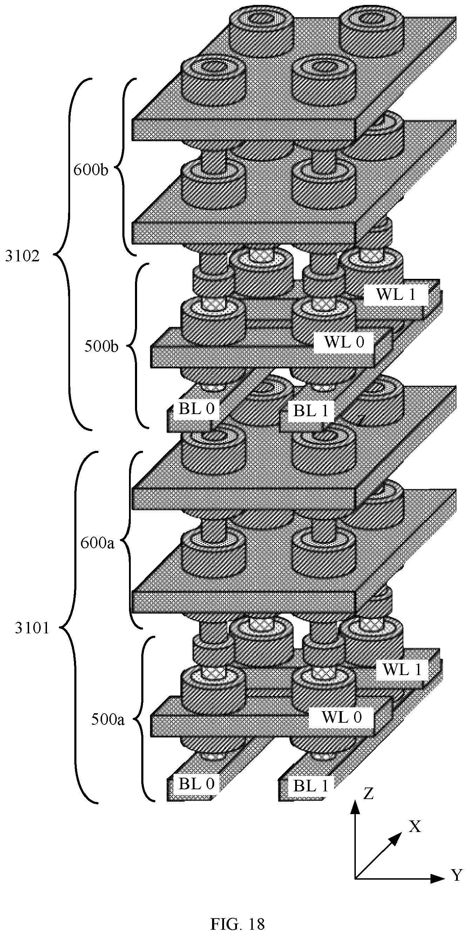

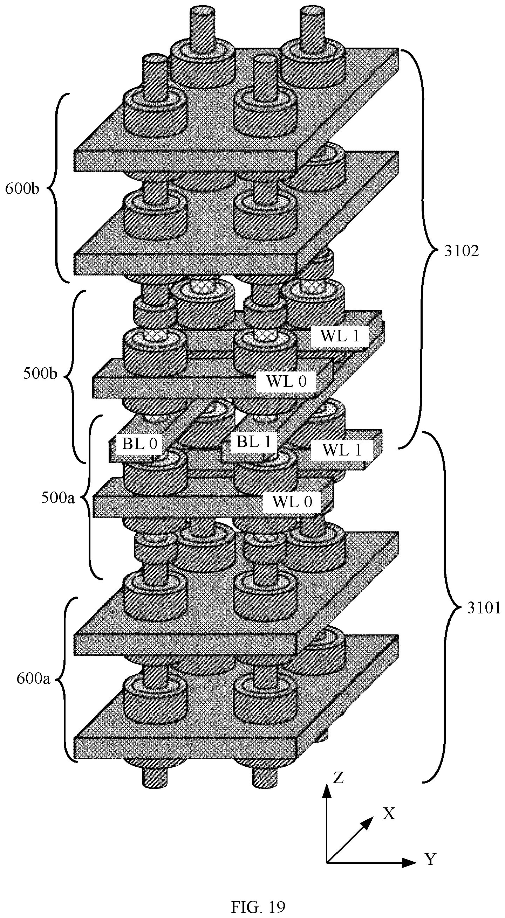

When the memory array structure layers shown in FIG. 15 to FIG. 17 are stacked in the Z direction perpendicular to the substrate, a 3D memory array structure may be formed. In FIG. 18 and FIG. 19, a memory including a first memory array layer 3101 and a second memory array layer 3102 is provided as an example.

In FIG. 18, transistors 500a of the first memory array layer 3101 are disposed close to a substrate relative to capacitor groups 600a formed by ferroelectric capacitors. Similarly, transistors 500b of the second memory array layer 3102 are also disposed close to the substrate relative to capacitor groups 600b formed by ferroelectric capacitors. In addition, the capacitor groups 600a of the first memory array layer 3101 and the transistors 500b of the second memory array layer 3102 are insulated by an insulation layer. In addition, each memory array layer has independent word lines WL, bit lines BL, and plate lines PL.

However, in FIG. 19, transistors 500a of the first memory array layer 3101 are disposed away from a substrate relative to capacitor groups 600a formed by ferroelectric capacitors, and transistors 500b of the second memory array layer 3102 are disposed close to the substrate relative to capacitor groups 600b formed by ferroelectric capacitors. In other words, the transistors 500a of the first memory array layer 3101 and the transistors 500b of the second memory array layer 3102 are close to each other. In this way, bit lines BL electrically connected to second electrodes of the transistors 500a of the first memory array layer 3101 and bit lines BL electrically connected to the second electrodes of the transistors 500b of the second memory array layer 3102 are shared, so that the size of each memory array layer in the direction perpendicular to the substrate can be reduced. In this way, more memory cells can be integrated in the direction perpendicular to the substrate, or more ferroelectric capacitors can be disposed on each memory cell.

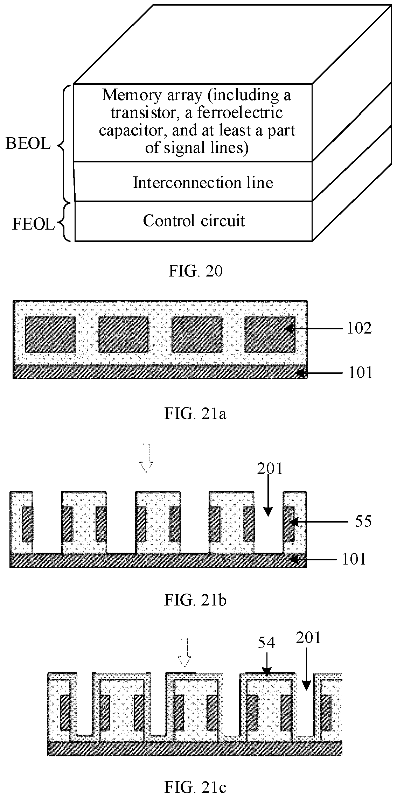

The ferroelectric memory disposed in this application may be manufactured through a back-end-of-line (back end of line, BEOL) process. FIG. 20 is a principle diagram of a back-end-of-line process. In FIG. 20, a control circuit is manufactured on a substrate through a front-end-of-line FEOL process. The control circuit may include one or more circuits of the following: the translator 320, the driver 330, the time sequence controller 340, the buffer 350, or the input/output driver 360 shown in FIG. 4, and may further include another functional circuit. The control circuit may control signal lines (a word line WL, a plate line PL, a bit line BL, and the like) in embodiments of this application. After the front-end-of-line process FEOL is completed, an interconnection line and a memory array are manufactured through the back-end-of-line BEOL process. As described above, the memory array herein includes the ferroelectric capacitors and the transistor in the memory cell, and also includes a part of the signal lines. The foregoing interconnection line not only includes an interconnection line connecting components in the control circuit, but also includes another part of the foregoing signal lines. The transistor in the memory array is manufactured through the back-end-of-line process, so that circuit density per unit area can be higher, thereby improving performance per unit area.

The following provides a manufacturing method of the ferroelectric memory provided in this application. For example, a control circuit is first formed on a substrate, an interconnection line is formed on the control circuit, and then a plurality of memory cells disposed in an array are formed on the interconnection line, so that the control circuit is electrically connected to the plurality of memory cells through the interconnection line, and read/write of the memory cells are controlled through the control circuit.

When the memory cells are being formed, a first electrode, a second electrode, a semiconductor layer, a gate, and a gate dielectric layer are formed in a direction perpendicular to the substrate, to form a transistor. A plurality of ferroelectric capacitors are formed in the direction perpendicular to the substrate, to form the memory cell.

This application provides specific manufacturing methods for obtaining a plurality of different memory cell structures, and the following respectively provides detailed explanations.

FIG. 21a to FIG. 21i are cross-sectional views of process structures that are after steps in a process of obtaining a memory cell in this application are completed.

As shown in FIG. 21a, a metal layer 101 and a metal layer 102 are stacked in a Z direction perpendicular to a substrate. The metal layer 101 and the metal layer 102 are insulated. There are a plurality of metal layers 102. The plurality of metal layers 102 are arranged at an interval in a direction parallel to the substrate. Every two adjacent metal layers 102 are insulated.

For example, in FIG. 21a, the plurality of metal layers 102 are arranged at an interval in an X direction. The metal layers 102 are continuously disposed in a Y direction perpendicular to both the X direction and the Z direction.

As shown in FIG. 21b, a first groove 201 is disposed at a position at which the metal layer 102 intersects the metal layer 101, so that the first groove 201 runs to the metal layer 101. A metal layer 102 located on a side of the first groove 201 is configured to form a gate 55 of a transistor.

The metal layer 101 herein may finally form first electrodes for electrically connecting a plurality of transistors arranged in the X direction. The first groove 201 runs through the metal layer 102. The first groove 201 herein is for forming a semiconductor layer therein, to form a GAA FET structure.

As shown in FIG. 21c, a gate dielectric layer 54 is formed in the first groove 201, where the gate dielectric layer 54 is disposed on wall surfaces of the first groove 201.

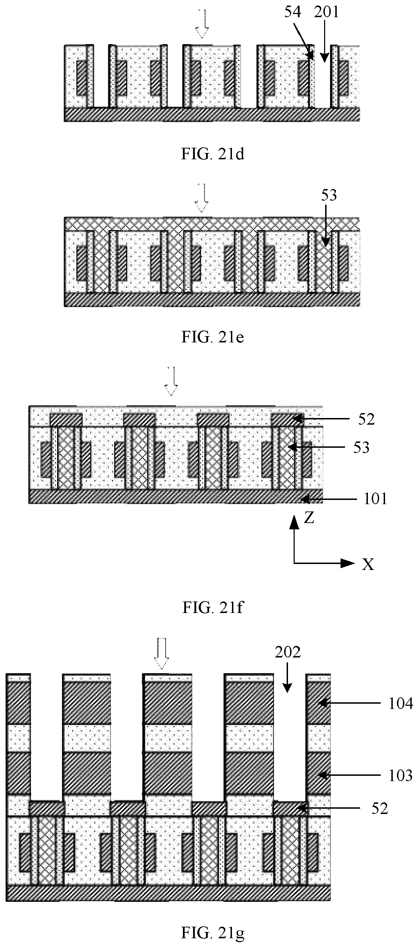

As shown in FIG. 21d, a gate dielectric layer 54 located on a bottom surface of the first groove 201 and a gate dielectric layer located above an insulation layer of the gate 55 are selectively etched. For example, etching may be performed through a dry etching process.

As shown in FIG. 21e, remaining space of the first groove 201 is filled with a semiconductor material, to form a semiconductor layer 53. In this way, a gate-all-around structure disposed around the semiconductor layer is formed in FIG. 21e.

As shown in FIG. 21f, a metal layer is disposed above the semiconductor layer 53, to form a second electrode 52 of the transistor. In this way, the GAA FET structure is obtained.

As shown in FIG. 21g, a plurality of metal layers are stacked above the second electrode 52. Two adjacent layers of the plurality of metal layers need to be insulated. For example, in FIG. 21g, a structure in which a memory cell has two ferroelectric capacitors needs to be manufactured. In this case, as shown in FIG. 21g, a metal layer 103 and a metal layer 104 are stacked above the second electrode 52.

In addition, a second groove 202 is disposed in the direction perpendicular to the substrate. The second groove 202 runs to the second electrode 52.

The metal layer 103 and the metal layer 104 herein are finally used as plate line layers for electrically connecting each layer of ferroelectric capacitors.

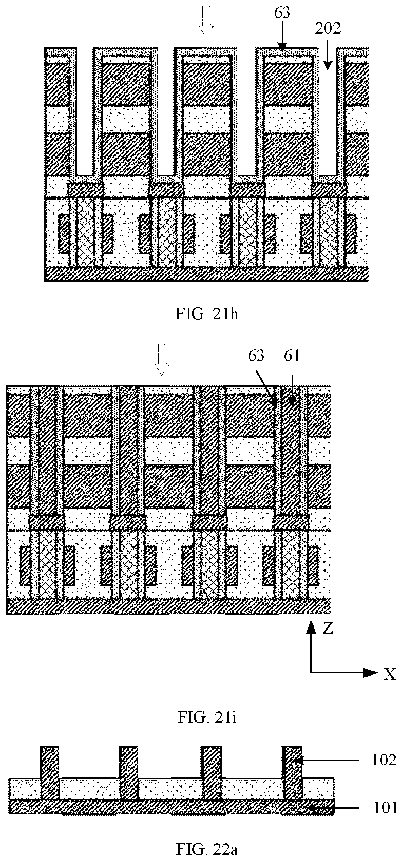

As shown in FIG. 21h, a ferroelectric layer 63 is formed in the second groove 202. The ferroelectric layer 63 is disposed on a wall surface of the second groove 202.

As shown in FIG. 21i, a first electrode layer 61 of a ferroelectric capacitor is formed in remaining space of the second groove 202. In this way, a plurality of memory cells are obtained. In addition, second electrode layers of a plurality of ferroelectric capacitors located in an X-Y plane are interconnected through the metal layer 103 shown in FIG. 21g. Alternatively, second electrode layers of a plurality of ferroelectric capacitors located in an X-Y plane are interconnected through the metal layer 104 shown in FIG. 21g.

FIG. 22a to FIG. 22i are cross-sectional views of process structures that are after steps in a process of obtaining another memory cell in this application are completed.

As shown in FIG. 22a, a metal layer 101 and a metal layer 102 are stacked in a Z direction perpendicular to a substrate. The metal layer 101 and the metal layer 102 are in contact. There are a plurality of metal layers 102. The plurality of metal layers 102 are arranged at an interval in a direction parallel to the substrate. Every two adjacent metal layers 102 are insulated. In addition, a part of the metal layer 102 is exposed to an insulation layer.

For example, in FIG. 22a, the plurality of metal layers 102 are arranged at an interval in an X direction. The metal layers 102 are continuously disposed in a Y direction perpendicular to both the X direction and the Z direction. The metal layer 102 herein is finally used as a gate 55 of a transistor.

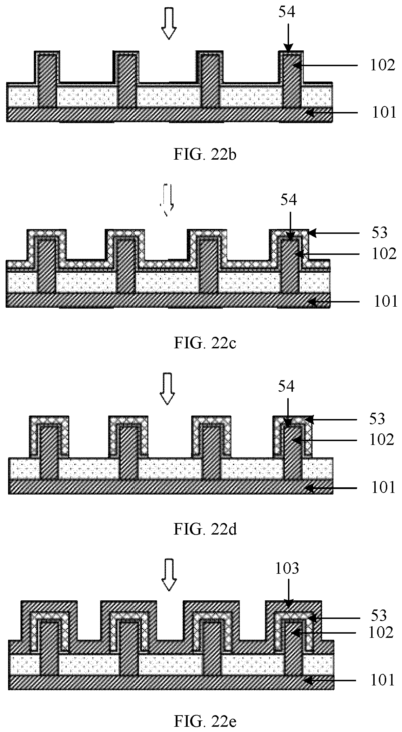

As shown in FIG. 22b, a gate dielectric layer 54 is formed, so that the gate dielectric layer 54 covers wall surfaces of the metal layers 102 exposed out of the insulation layer.

As shown in FIG. 22c, a semiconductor layer 53 is further formed on the gate dielectric layer 54.

As shown in FIG. 22d, a gate dielectric layer 54 and a semiconductor layer 53 that are located between two adjacent metal layers 102 and that are in contact with the insulation layer are selectively etched, to obtain a structure shown in FIG. 22d.

As shown in FIG. 22e, a metal layer 103 is formed. The metal layer 103 covers the semiconductor layer 53.

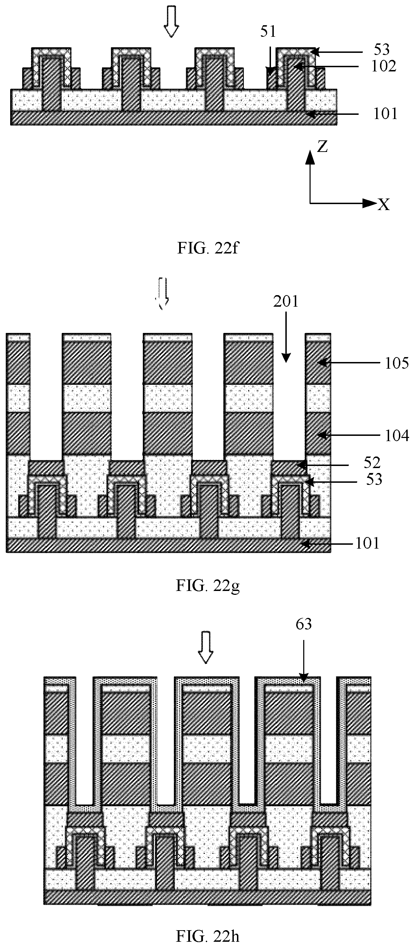

As shown in FIG. 22f, a metal layer 103 on an upper surface of the semiconductor layer 53 and a metal layer 103 on an upper part of a side surface of the semiconductor layer 53 are selectively etched, and a metal layer on a lower part of the side surface of the semiconductor layer 53 forms a first electrode 51 of the transistor.

As shown in FIG. 22g, a metal layer is disposed above the semiconductor layer 53, to form a second electrode 52 of the transistor. In this way, a CAA FET structure is obtained.

A plurality of metal layers are stacked above the second electrode 52. Two adjacent layers of the plurality of metal layers need to be insulated. For example, in FIG. 22g, a structure in which a memory cell has two ferroelectric capacitors needs to be manufactured. In this case, as shown in FIG. 22g, a metal layer 104 and a metal layer 105 are stacked above the second electrode 52.

In addition, a first groove 201 is disposed in the direction perpendicular to the substrate. The first groove 201 runs to the second electrode 52.

The metal layer 104 and the metal layer 105 herein are finally used as plate line layers for electrically connecting each layer of ferroelectric capacitors.

As shown in FIG. 22h, a ferroelectric layer 63 is formed in the first groove 201. The ferroelectric layer 63 is disposed on a wall surface of the first groove 201.

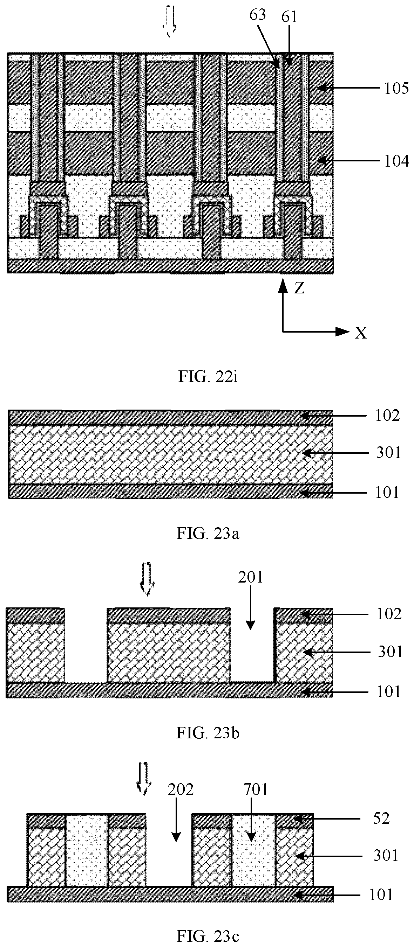

As shown in FIG. 22i, a first electrode layer 61 of a ferroelectric capacitor is formed in remaining space of the first groove 201. In this way, a plurality of memory cells are obtained.

FIG. 23a to FIG. 23i are cross-sectional views of process structures that are after steps in a process of obtaining another memory cell in this application are completed.

As shown in FIG. 23a, a metal layer 101, a sacrificial layer 301, and a metal layer 102 are stacked in a Z direction perpendicular to a substrate.

The metal layer 101 herein is finally used as a bit line BL for electrically connecting first electrodes of transistors.

As shown in FIG. 23b, a plurality of first grooves 201 are disposed at an interval in a Y direction parallel to the substrate. The first grooves 201 run through the metal layer 102 and the sacrificial layer 301. In other words, the first grooves 201 cannot run through the metal layer 101, because the metal layer 101 is finally used as the bit line BL of a memory array.

As shown in FIG. 23c, a first groove 201 is filled with an insulation material to form an insulation layer 701. In addition, a second groove 202 is further disposed. The second groove 202 is located between two adjacent insulation layers 701, and the second groove 202 runs through the metal layer 102 and the sacrificial layer 301.

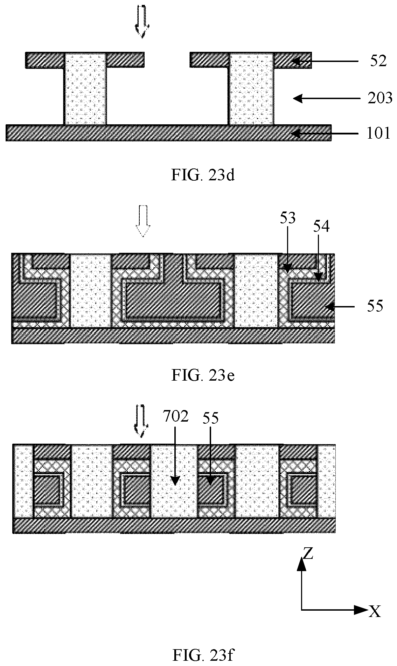

As shown in FIG. 23d, the sacrificial layer 301 in contact with the insulation layer 701 is removed, to form a plurality of recess cavities 203 shown in FIG. 23d. In this way, a semiconductor layer, a gate dielectric layer, and a gate can be formed in the recess cavity 203.

In some optional implementations, a corrosion process may be selected to remove the sacrificial layer 301. For example, when the sacrificial layer 301 is made of silicon oxide, a hydrofluoric acid corrosion medium may be used for corrosion.

As shown in FIG. 23e, a semiconductor layer 53, a gate dielectric layer 54, and a gate 55 are formed on wall surfaces of the recess cavity 203.

With reference to FIG. 23f, when gates 55 are being formed, gates 55 of two adjacent memory cells in the Y direction are connected as a whole. Therefore, as shown in FIG. 23f, a groove is disposed, so that the gates 55 of the two adjacent memory cells in the Y direction are disconnected. An insulation layer 702 is formed in the groove, so that the gates 55 of the two adjacent memory cells in the Y direction are insulated.

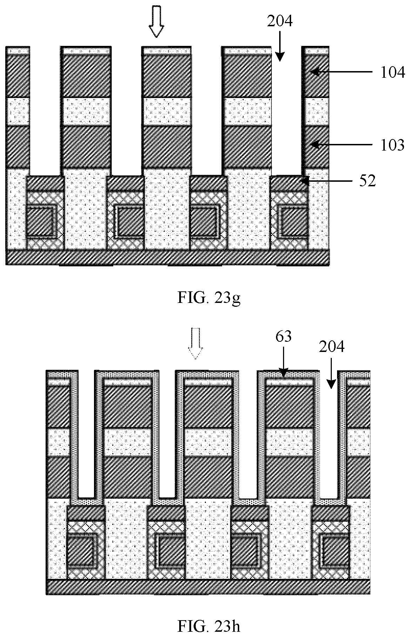

As shown in FIG. 23g, a plurality of metal layers are stacked above the second electrode 52. Two adjacent layers of the plurality of metal layers need to be insulated. For example, in FIG. 23g, a structure in which a memory cell has two ferroelectric capacitors needs to be manufactured. In this case, as shown in FIG. 23g, a metal layer 103 and a metal layer 104 are stacked above the second electrode 52.

In addition, a third groove 204 is disposed in the direction perpendicular to the substrate. The third groove 204 runs to the second electrode 52.

The metal layer 103 and the metal layer 104 herein are finally used as plate line layers for electrically connecting each layer of ferroelectric capacitors.

As shown in FIG. 23h, a ferroelectric layer 63 is formed in the third groove 204. The ferroelectric layer 63 is disposed on a wall surface of the third groove 204.

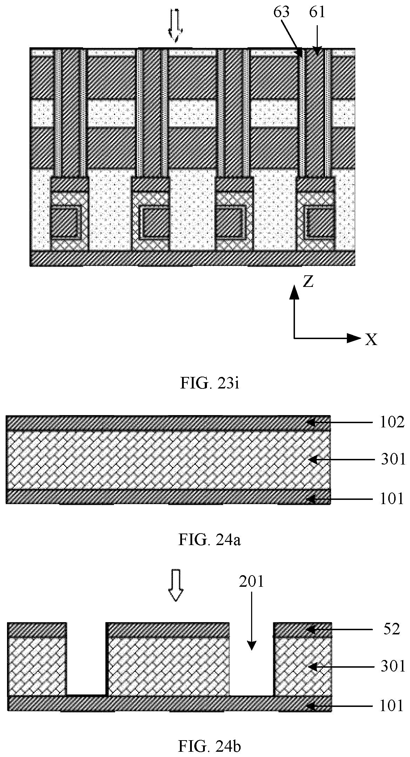

As shown in FIG. 23i, a first electrode layer 61 of a ferroelectric capacitor is formed in remaining space of the third groove 204. In this way, a plurality of memory cells are obtained.

FIG. 24a to FIG. 24i are cross-sectional views of process structures that are after steps in a process of obtaining another memory cell in this application are completed.

As shown in FIG. 24a, a metal layer 101, a sacrificial layer 301, and a metal layer 102 are stacked in a Z direction perpendicular to a substrate.

The metal layer 101 herein is finally used as a bit line BL for electrically connecting first electrodes of transistors.

As shown in FIG. 24b, a plurality of first grooves 201 are disposed at an interval in a Y direction parallel to the substrate. The first grooves 201 run through the metal layer 102 and the sacrificial layer 301. In other words, the first grooves 201 cannot run through the metal layer 101, because the metal layer 101 is finally used as the bit line BL of a memory array. In addition, a second electrode 52 of a transistor is formed because the metal layer 101 is broken.

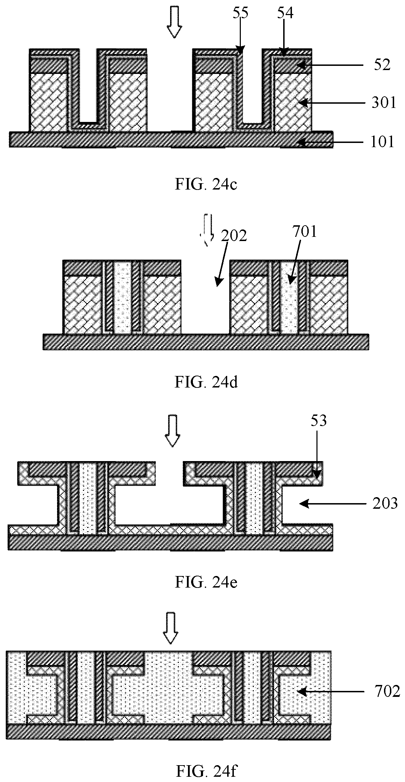

As shown in FIG. 24c, a gate dielectric layer 54 and a gate 55 are formed in a first groove 201.

As shown in FIG. 24d, remaining space of the first groove 201 is filled with an insulation material, to form an insulation layer 701. In addition, a second groove 202 is disposed between adjacent insulation layers 701. The second groove 202 runs to the metal layer 101.

As shown in FIG. 24e, the sacrificial layer 301 in contact with the insulation layer 701 is removed, to form a plurality of recess cavities 203 shown in FIG. 24e. In this way, a semiconductor layer 53 can be formed in a recess cavity 203.

As shown in FIG. 24f, remaining space of the recess cavity 203 is filled with an insulation meterial, to form an insulation layer 702.

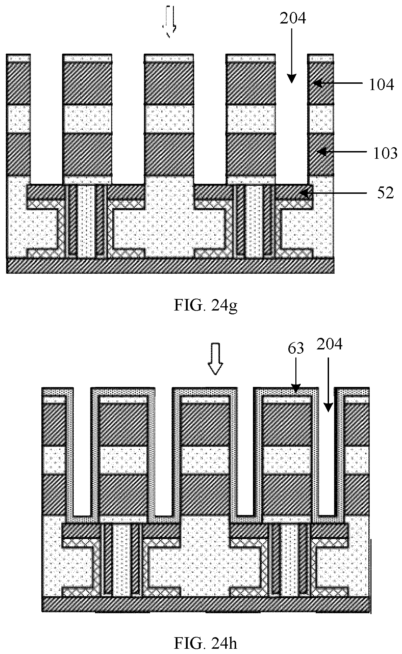

As shown in FIG. 24g, a plurality of metal layers are stacked above the second electrode 52. Two adjacent layers of the plurality of metal layers need to be insulated. For example, in FIG. 24g, a structure in which a memory cell has two ferroelectric capacitors needs to be manufactured. In this case, as shown in FIG. 24g, a metal layer 103 and a metal layer 104 are stacked above the second electrode 52.

In addition, a third groove 204 is disposed in the direction perpendicular to the substrate. The third groove 204 runs to the second electrode 52.

The metal layer 103 and the metal layer 104 herein are finally used as plate line layers for electrically connecting each layer of ferroelectric capacitors.

As shown in FIG. 24h, a ferroelectric layer 63 is formed in the third groove 204. The ferroelectric layer 63 is disposed on a wall surface of the third groove 204.

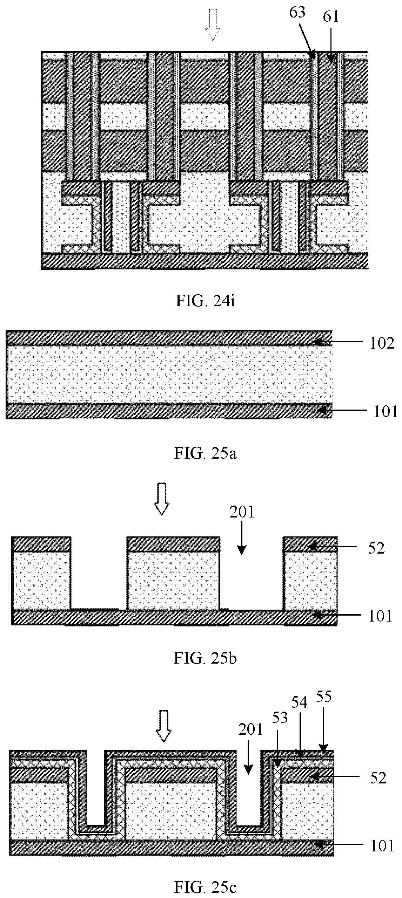

As shown in FIG. 24i, a first electrode layer 61 of a ferroelectric capacitor is formed in remaining space of the third groove 204. In this way, a plurality of memory cells are obtained.

FIG. 25a to FIG. 25i are cross-sectional views of process structures that are after steps in a process of obtaining another memory cell in this application are completed.

As shown in FIG. 25a, a metal layer 101 and a metal layer 102 are stacked in a Z direction perpendicular to a substrate. There is an insulation layer between the metal layer 101 and the metal layer 102.

The metal layer 101 herein is finally used as a bit line BL for electrically connecting first electrodes of transistors.

As shown in FIG. 25b, a plurality of first grooves 201 are disposed at an interval in a Y direction parallel to the substrate. The first grooves 201 run through the insulation layer to the metal layer 101. In addition, a second electrode 52 of a transistor is formed because the metal layer 101 is broken.

As shown in FIG. 25c, a semiconductor layer 53, a gate dielectric layer 54, and a gate 55 are sequentially formed in a first groove 201.

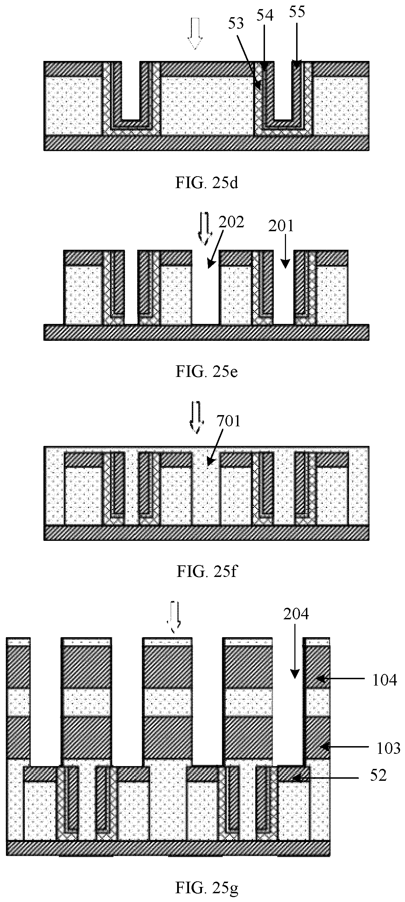

As shown in FIG. 25d, a semiconductor layer 53, a gate dielectric layer 54, and a gate 55 that are on a surface of the metal layer 102 are selectively etched.

As shown in FIG. 25e, a semiconductor layer 53, a gate dielectric layer 54, and a gate 55 that are on a bottom surface of the first groove 201 are selectively etched. In addition, a second groove 202 is disposed between two adjacent first grooves 201.

As shown in FIG. 25f, remaining space of the first groove 201 and the second groove 202 are filled with an insulation material, to form an insulation layer 701.

As shown in FIG. 25g, a plurality of metal layers are stacked above the second electrode 52. Two adjacent layers of the plurality of metal layers need to be insulated. For example, in FIG. 24g, a structure in which a memory cell has two ferroelectric capacitors needs to be manufactured. In this case, as shown in FIG. 24g, a metal layer 103 and a metal layer 104 are stacked above the second electrode 52.

In addition, a third groove 204 is disposed in the direction perpendicular to the substrate. The third groove 204 runs to the second electrode 52.

The metal layer 103 and the metal layer 104 herein are finally used as plate line layers for electrically connecting each layer of ferroelectric capacitors.

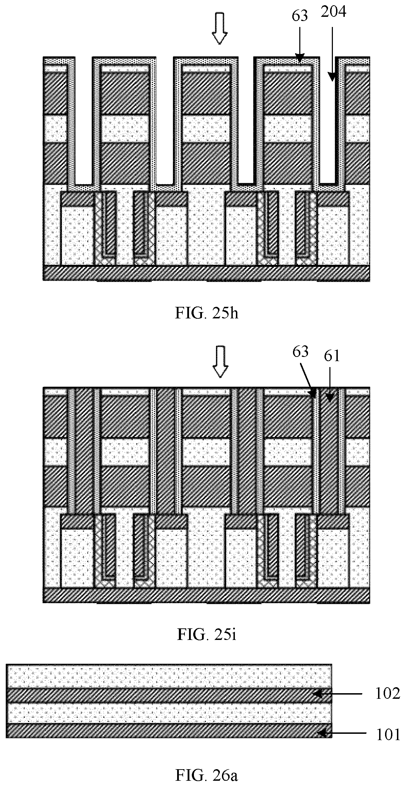

As shown in FIG. 25h, a ferroelectric layer 63 is formed in the third groove 204. The ferroelectric layer 63 is disposed on a wall surface of the third groove 204.

As shown in FIG. 25i, a first electrode layer 61 of a ferroelectric capacitor is formed in remaining space of the third groove 204. In this way, a plurality of memory cells are obtained.

FIG. 26a to FIG. 26i are cross-sectional views of process structures that are after steps in a process of obtaining another memory cell in this application are completed.

As shown in FIG. 26a, a metal layer 101 and a metal layer 102 are stacked in a Z direction perpendicular to a substrate. There is an insulation layer between the metal layer 101 and the metal layer 102, and there is also an insulation layer on a side that is of the metal layer 102 and that is away from the metal layer 101.

The metal layer 101 herein is finally used as a bit line BL for electrically connecting first electrodes of transistors.

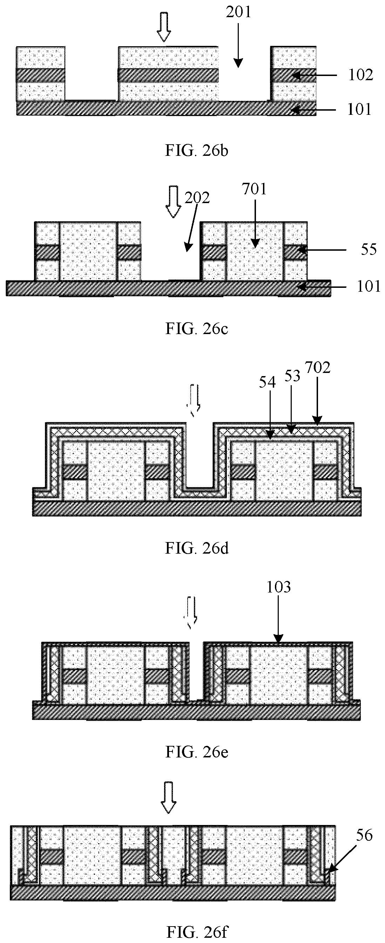

As shown in FIG. 26b, a plurality of first grooves 201 are disposed at an interval in a Y direction parallel to the substrate. The first grooves 201 run through the insulation layer to the metal layer 101. In addition, a gate 55 of the transistor is formed because the metal layer 101 is broken.

As shown in FIG. 26c, a first groove 201 is filled with an insulation material, to form an insulation layer 701. In addition, a second groove 202 is disposed between two adjacent insulation layers 701. The second groove 202 runs to the metal layer 101.

As shown in FIG. 26d, a gate dielectric layer 54, a semiconductor layer 53, and an insulation layer 702 are sequentially filled in the second groove 202.

As shown in FIG. 26e, a gate dielectric layer 54, a semiconductor layer 53, and an insulation layer 702 that are on a bottom surface of the second groove 202 are selectively etched. In other words, a gate dielectric layer 54, a semiconductor layer 53, and an insulation layer 702 that are on a side surface of the second groove 202 are reserved. In addition, a metal layer 103 is formed in the second groove 202.

As shown in FIG. 26f, a metal layer 103 on an upper part of a side surface of the second groove 202 is selectively etched, and a metal layer 103 of a lower part of the side surface of the second groove 202 is reserved, so that the lower part forms a connection electrode 56.

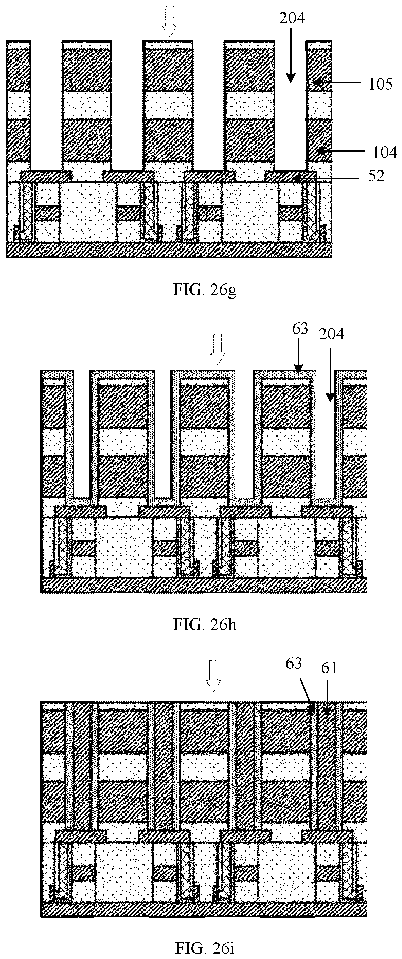

As shown in FIG. 26g, a second electrode 52 in contact with the semiconductor layer 53 is formed, and a plurality of metal layers are stacked above the second electrode 52. Two adjacent layers of the plurality of metal layers need to be insulated. For example, in FIG. 26g, a structure in which a memory cell has two ferroelectric capacitors needs to be manufactured. In this case, as shown in FIG. 26g, a metal layer 104 and a metal layer 105 are stacked above the second electrode 52.

In addition, a third groove 204 is disposed in the direction perpendicular to the substrate. The third groove 204 runs to the second electrode 52.

The metal layer 104 and the metal layer 105 herein are finally used as plate line layers for electrically connecting each layer of ferroelectric capacitors.

As shown in FIG. 26h, a ferroelectric layer 63 is formed in the third groove 204. The ferroelectric layer 63 is disposed on a wall surface of the third groove 204.

As shown in FIG. 26i, a first electrode layer 61 of a ferroelectric capacitor is formed in remaining space of the third groove 204. In this way, a plurality of memory cells are obtained.

Based on the foregoing memory cells that are of different structures and that are obtained through different processes, the transistors and the plurality of ferroelectric capacitors are arranged in the direction perpendicular to the substrate, so that more memory cells can be obtained above the substrate, thereby improving storage capacity of the memory and improving a read/write speed of the memory.

In the descriptions of this specification, the specific features, structures, materials, or characteristics may be combined in an appropriate manner in any one or more of embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A ferroelectric memory, comprising:
a substrate; and
a plurality of memory cells, formed on the substrate, wherein
each memory cell comprises a transistor and a plurality of ferroelectric capacitors;
the transistor and the plurality of ferroelectric capacitors are arranged in a first direction perpendicular to the substrate;
any ferroelectric capacitor comprises a first electrode layer, a second electrode layer, and a ferroelectric layer formed between the first electrode layer and the second electrode layer;
the first electrode layers of every two adjacent ferroelectric capacitors of the plurality of ferroelectric capacitors are in contact, to form a shared first electrode layer that extends in the first direction; and
the shared first electrode layer is electrically connected to the transistor.

2. The ferroelectric memory according to claim 1, wherein the ferroelectric memory further comprises a plate line layer, wherein the plate line layer is located on a first plane parallel to the substrate; and
the plurality of second electrode layers of the plurality of ferroelectric capacitors located on the first plane are interconnected through the plate line layer.

3. The ferroelectric memory according to claim 1 or 2, wherein the transistor and the plurality of ferroelectric capacitors are all manufactured through a back-end-of-line process.

4. The ferroelectric memory according to any one of claims 1 to 3, wherein the transistor comprises a gate, a semiconductor layer, a first electrode, a second electrode, and a gate dielectric layer, wherein
the first electrode and the second electrode are arranged in the first direction, the gate is a vertical structure that extends in the first direction, one of two opposite sides of the gate in a second direction has the semiconductor layer, the semiconductor layer is electrically connected to the first electrode and the second electrode, the gate and the semiconductor layer are isolated by the gate dielectric layer, and the second direction is a direction parallel to the substrate.

5. The ferroelectric memory according to claim 4, wherein the semiconductor layer is a vertical structure that extends in the first direction, one of two opposite ends of the semiconductor layer in the first direction is in contact with the first electrode, and the other end is in contact with the second electrode.

6. The ferroelectric memory according to claim 5, wherein a surface opposite to the second electrode in the first electrode is a first wall surface, and a surface opposite to the first electrode in the second electrode is a second wall surface; and
the one of the opposite two ends of the semiconductor layer in the first direction is in contact with the first wall surface, and the other end is in contact with the second wall surface.

7. The ferroelectric memory according to claim 5, wherein a surface opposite to the second electrode in the first electrode is a first wall surface, and a surface that is in the first electrode and that is adjacent to the first wall surface is a first side surface;
a surface opposite to the first electrode in the second electrode is a second wall surface, a surface that is in the second electrode and that is adjacent to the second wall surface is a second side surface, and the first side surface and the second side surface are located on a same side; and
the one of the opposite two ends of the semiconductor layer in the first direction is in contact with the first side surface, and the other end is in contact with the second side surface.

8. The ferroelectric memory according to claim 4, wherein the semiconductor layer comprises a first part and a second part both of which extend in the second direction, and a third part that extends in the first direction and that is connected to both the first part and the second part;
a surface opposite to the second electrode in the first electrode is a first wall surface, and a surface opposite to the first electrode in the second electrode is a second wall surface; and
the first part is disposed on the first wall surface, and the second part is disposed on the second wall surface.

9. The ferroelectric memory according to claim 4, wherein the semiconductor layer comprises a first part that extends in the second direction, and a third part that extends in the first direction and that is connected to the first part;
a surface opposite to the second electrode in the first electrode is a first wall surface, and a surface opposite to the first electrode in the second electrode is a second wall surface;
the ferroelectric memory further comprises a connection electrode, and the connection electrode is disposed on the second wall surface; and
the third part is in contact with the first wall surface, and the first part is in contact with the connection electrode.

10. The ferroelectric memory according to any one of claims 4 to 9, wherein the surface opposite to the second electrode in the first electrode is the first wall surface, and the surface opposite to the first electrode in the second electrode is the second wall surface; and
the gate is located in a region between the first wall surface and the second wall surface.

11. The ferroelectric memory according to any one of claims 4 to 9, wherein the surface opposite to the second electrode in the first electrode is the first wall surface, and the surface that is in the first electrode and that is adjacent to the first wall surface is the first side surface;
the surface opposite to the first electrode in the second electrode is the second wall surface, the surface that is in the second electrode and that is adjacent to the second wall surface is the second side surface, and the first side surface and the second side surface are located on a same side; and
the gate is located on the side on which the first side surface and the second side surface are located.

12. The ferroelectric memory according to any one of claims 1 to 3, wherein the transistor is manufactured through a gate-all-around GAA process.

13. The ferroelectric memory according to any one of claims 1 to 3, wherein the transistor is manufactured through a channel-all-around CAA process.

14. The ferroelectric memory according to claim 13, wherein the transistor comprises a gate, a semiconductor layer, a first electrode, a second electrode, and a gate dielectric layer, wherein
the first electrode and the second electrode are arranged in the first direction, the gate is a vertical structure that extends in the first direction, the semiconductor layer surrounds the outside of the gate, the semiconductor layer and the gate are isolated by the gate dielectric layer, the first electrode surrounds the periphery of the semiconductor layer and is electrically connected to the semiconductor layer, and the semiconductor layer is electrically connected to the second electrode.

15. The ferroelectric memory according to any one of claims 1 to 14, wherein the ferroelectric memory further comprises:
a bit line, a word line, and a plate line, wherein
the gate of the transistor is electrically connected to the word line;
the first electrode of the transistor is electrically connected to the bit line;
the second electrode of the transistor is electrically connected to the shared first electrode layer; and
the second electrode layer of the ferroelectric capacitor is electrically connected to the plate line.

16. The ferroelectric memory according to claim 15, wherein the plurality of memory cells form a first memory array layer and a second memory array layer that are arranged in the first direction;
the transistor in the first memory array layer is disposed away from the substrate relative to the plurality of ferroelectric capacitors; and
the transistor in the second memory array layer is disposed close to the substrate relative to the plurality of ferroelectric capacitors.

17. The ferroelectric memory according to claim 16, wherein
the bit line that is in the first memory array layer and that is electrically connected to the transistor shares a same signal line with the bit line that is in the second memory array layer and that is electrically connected to the transistor.

18. The ferroelectric memory according to any one of claims 15 to 17, wherein the ferroelectric memory further comprises a controller, and the controller is configured to:
output a word line control signal to control a voltage on the word line;
output a plate line control signal to control a voltage on the plate line; and
output a bit line control signal to control a voltage on the bit line.

19. A ferroelectric memory, comprising:
a word line, a bit line, a plate line; and
a plurality of memory cells, wherein each of the memory cells comprises:
a transistor and a plurality of ferroelectric capacitors, wherein
any ferroelectric capacitor comprises a first electrode layer, a second electrode layer, and a ferroelectric layer formed between the first electrode layer and the second electrode layer, and the transistor comprises a first electrode, a second electrode, and a gate; and
the first electrode of the transistor is electrically connected to the bit line, the second electrode of the transistor is electrically connected to the plurality of first electrode layers of the plurality of ferroelectric capacitors, the gate of the transistor is electrically connected to the word line, and the second electrode layer of the ferroelectric capacitor is electrically connected to the plate line.

20. The ferroelectric memory according to claim 19, wherein the transistor and the plurality of ferroelectric capacitors are all manufactured through a back-end-of-line process.

21. The ferroelectric memory according to claim 19 or 20, wherein
in a write stage, the word line is configured to receive a first word line electrical control signal, so that the transistor is turned on, the bit line is configured to receive a first bit line control signal, the plate line electrically connected to a selected ferroelectric capacitor is configured to receive a first plate line control signal, and a voltage difference between the first bit line control signal and the first plate line control signal enables polarization of the ferroelectric layer of the selected ferroelectric capacitor.

22. The ferroelectric memory according to any one of claims 19 to 21, wherein
in a first read stage, the word line is configured to receive the first word line electrical control signal, so that the transistor is turned on, and the bit line is configured to receive a second bit line control signal, to perform voltage pre-charging on the first electrode layer of the selected ferroelectric capacitor;
in a second read stage, the word line is configured to receive a second word line electrical control signal, so that the transistor is turned off, the plate line electrically connected to the selected ferroelectric capacitor is configured to receive a second plate line control signal, and a voltage difference between the second plate line control signal and the first electrode layer keeps a polarization direction of the ferroelectric layer of the selected ferroelectric capacitor unchanged, or reverses the polarization direction of the ferroelectric layer of the selected ferroelectric capacitor; and
in a third read stage, the word line is configured to receive the first word line electrical control signal, so that the transistor is turned on, and a voltage or a current on the bit line is detected to read information stored by the selected ferroelectric capacitor.

23. An electronic device, comprising:
a processor; and
the ferroelectric memory according to any one of claims 1 to 22, wherein the processor is electrically connected to the ferroelectric memory.

24. The electronic device according to claim 23, wherein
the processor and the ferroelectric memory are integrated into a same chip.

25. A forming method of a ferroelectric memory, comprising:
forming a transistor on a substrate; and
forming a plurality of ferroelectric capacitors, wherein the transistor and the plurality of ferroelectric capacitors form a memory cell, the transistor and the plurality of ferroelectric capacitors are arranged in a first direction perpendicular to the substrate, any ferroelectric capacitor comprises a first electrode layer, a second electrode layer, and a ferroelectric layer formed between the first electrode layer and the second electrode layer, the first electrode layers of every two adjacent ferroelectric capacitors of the plurality of ferroelectric capacitors are in contact, to form a shared first electrode layer that extends in the first direction, and the shared first electrode layer is electrically connected to the transistor.

26. The forming method of the ferroelectric memory according to claim 25, wherein before the memory cell is formed, the forming method further comprises:
forming a control circuit on the substrate; and
forming, on the control circuit, an interconnection line that electrically connects the control circuit and the memory cell.
